(19) 

Europäisches
Patentamt
European
Patent Office
Office européen
des brevets

(11) **EP 1 927 891 A1**

(12) **EUROPEAN PATENT APPLICATION**

(43) Date of publication:
**04.06.2008 Bulletin 2008/23**

(51) Int Cl.:
*G03F 7/20* (2006.01) *G02B 17/08* (2006.01)

(21) Application number: **06024790.5**

(22) Date of filing: **30.11.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **Carl Zeiss SMT AG
73447 Oberkochen (DE)**

(72) Inventor: **Epple, Alexander
73431 Aalen (DE)**

(74) Representative: **Patentanwälte
Ruff, Wilhelm, Beier, Dauster & Partner
Kronenstrasse 30
70174 Stuttgart (DE)**

(54) **Projection objective with conjugated pupils**

(57) A projection objective comprises a plurality of optical elements arranged to image an object field arranged in an object surface onto an image field arranged in an image surface of the projection objective without pupil obscuration. The optical elements form a first, refractive objective part generating a first intermediate image from radiation coming from the object surface and including a first pupil surface; and an imaging subsystem immediately following the first objective part configured to image the first intermediate image onto the image surface. Optical elements arranged between the object surface and the first pupil surface form a Fourier lens group configured to produce a chief ray angle $CRA_{P1} < 25°$ at the first pupil surface.

Fig. 1

**Description**

BACKGROUND OF THE INVENTION

Field of the Invention

The invention relates to a projection objective comprising a plurality of optical elements arranged to image an object field arranged in an object surface of the projection objective onto an image field arranged in an image surface of the projection objective.

Description of the Related Art

Microlithographic processes are commonly used in the manufacture of semiconductor elements, such as integrated circuits (ICs) liquid crystal elements, micropatterned members and micromechanical components.

A projection exposure apparatus used for photolithography generally comprises an illumination system configured to transform primary radiation from a light source into illumination radiation, and a projection objective. Light from the illumination system illuminates a reticle (or mask) having a given pattern, and the projection objective transfers an image of the pattern onto a region of a photo-sensitive substrate arranged in the image surface of the projection objective. Projection is typically performed with high resolution on a reduced scale to produce a demagnified image of the reticle pattern on the substrate.

In order to create even finer structures, it is sought to both increase the image-side numerical aperture (NA) of the projection objective and employ shorter wavelengths, preferably ultraviolet light with wavelengths less than about 260 nm. However, there are very few materials, in particular, synthetic quartz glass and crystalline fluorides, that are sufficiently transparent in that wavelength region available for fabricating the optical elements. Since the Abbe numbers of those materials that are available lie rather close to one another, it is difficult to provide purely refractive systems that are sufficiently well color-corrected (corrected for chromatic aberrations).

In optical lithography, high resolution and good correction status have to be obtained for a relatively large, virtually planar image field. It has been pointed out that the most difficult requirement that one can ask of any optical design is that it have a flat image, especially if it is an all-refractive design. Providing a flat image requires opposing lens powers and that typically leads to stronger lenses, more system length, larger system glass mass, and larger higher-order image aberrations that result from the stronger lens curvatures.

Applicant's US patent application US 2006/0056064 A1 discloses embodiments of purely refractive projection objectives designed for about 193nm wavelength having image-side numerical apertures NA greater than 1, a good imaging performance and relatively small diameters of lenses. The projection objectives are configured to generate exactly one real intermediate image of the object field and to image the intermediate image into the region of the image field. To this end, a first, refractive objective part generates a first intermediate image, and a purely refractive imaging subsystem immediately following the first objective part is configured to image the first intermediate image onto the image surface.

Concave mirrors have been used for some time to help solve problems of color correction and image flattening. A concave mirror has positive power, like a positive lens, but the opposite sign of Petzval curvature. Also, concave mirrors do not introduce chromatic aberrations. Therefore, catadioptric systems that combine refracting and reflecting elements, particularly lenses and at least one concave mirror, are often employed for configuring high-resolution projection objectives for microlithography.

Unfortunately, a concave mirror is difficult to integrate into an optical design, since it sends the radiation right back in the direction it came from. Intelligent designs integrating concave mirrors are desirable.

Some concepts of catadioptric projection objectives allowing high image-side numerical aperture NA and a good correction status include projection objectives comprising three or more cascaded (or concatenated) imaging objective parts and two or more intermediate images. In some designs having exactly two intermediate images, a first refractive objective part (abbreviation "R") generates a first real intermediate image of an object. A second, catadioptric or catoptric objective part (abbreviation "C") including at least one concave mirror generates a real second intermediate image from the first intermediate image. A third, refractive objective part images the second intermediate image into the image plane. A pupil surface is formed in each imaging objective part, such that three optically conjugated pupil surfaces are present. Typically, the first, refractive objective part serves as a "relay" system to define the size, position and correction status of the first intermediate image properly for the subsequent imaging steps. The second objective part typically corrects a major amount of image field curvature (Petzval correction) and, depending on design, a contribution to chromatic correction is made. The third objective part typically is optimized as a focusing group with densely packed lenses to obtain the desired image-side NA.

Applicant's US patent US 6,660,608 B1 shows examples of unfolded catadioptric projection objectives of general type R-C-R having a straight optical axis common to all optical elements. A catoptric or catadioptric second objective part interposed between an object-side first refractive object part creating a first intermediate image and an image-side last refractive objective part imaging a last intermediate image onto the image surface includes two concave mirrors with facing reflecting surfaces. Both concave mirrors have a central hole on the optical axis and are positioned optically close to the second pupil surface. Due to the non-reflecting section of the mirrors at the holes the system has a central pupil obscuration. One advantage of those embodiments is that an on-axis object field and image field can be used. A pupil obscuration may be problematic in certain types of exposures processes depending on illumination mode and the characteristics of the structures to be printed. Also, in systems with pupil obscuration it is difficult to keep the size of the obscuration small as the image-side numerical aperture is increased. Therefore, although obscured systems may have a very good performance at relatively low image-side NA, such as NA = 0.75, obscured systems are sometimes considered as aperture limited.

Other types of type R-C-R catadioptric projection objectives use an off-axis object field and image field, whereby pupil obscuration may be avoided.

One class of type R-C-R concatenated systems with off-axis fields uses a single concave mirror positioned at or optically close to the pupil surface of the second objective part in combination with one or more negative lenses arranged ahead of the concave mirror to correct axial chromatic aberration (CHL) and Petzval sum. A deflection of rays between object surface and the concave mirror and between the concave mirror and the image surface is often accomplished by a deflection system having two plane folding mirrors oriented at a right angles with respect to each other, where both folding mirrors are positioned optically close to intermediate images. A parallel orientation of object surface and image surface is thereby obtained. The planar folding mirrors oriented obliquely to the incident radiation may introduce changes of the polarization state of the deflected radiation which are difficult to avoid or compensate. Representative examples for folded catadioptric projection objectives using planar folding mirrors in combination with a single concave mirror are disclosed, for example in US 2003/02344912 A1 or US 2004/0233405 A1 or WO 2005/111689 A2.

International patent application WO 2005/040890 A2 or US patent application US 2005/0185269 A1 disclose embodiments of catadioptric projection objectives with off-axis fields having three real intermediate images between object surface and image surface. A catadioptric objective part interposed between an object-side first refractive objective part creating the first intermediate image and an image-side last refractive objective part imaging a last intermediate image onto the image surface includes two concave mirrors and an intermediate image formed therebetween. Planar folding mirrors are provided to deflect radiation between different parts of the projection objective.

Applicant's US Patent application US 2005/0190435 A1 shows various examples of unfolded catadioptric projection objectives with off-axis fields, the objectives having a straight optical axis common to all optical elements. The second objective part includes two concave mirrors facing each other and defining an intermirror space, where at least the first intermediate image lies inside that intermirror space. Both concave mirrors are optically remote from pupil surface, i.e. optically nearer to the first and second intermediate image, respectively. No bores or holes exist in the reflecting areas of the mirrors.

Due to the increasing demands on the effiency of the lithographic manufacturing process there is a tendency to increase the power of the light sources. Also, progressively shorter wavelengths are used. Specific illumination settings are employed to optimize the imaging conditions for various pattern types. As a result, various time-dependent changes in the properties of optical materials within the projection system are observed, which sensibly affect the imaging quality of the exposure system. The heating of lens groups and other transparent optical elements ("lens heating") during operation due to an increased absorption is one effect dynamically influencing the imaging properties. Also, long-term (quasi-static) effects due to radiation induced refractive index variations, such as compaction effects, are observed.

Also, since calcium fluoride and other optical materials typically used in projection objective for DUV (deep ultraviolet) and VUV (very deep ultraviolet) applications exhibit intrinsic birefringence and may also cause polarization effects due to stress birefringence in response to mechanical stress imposed thereon, it is generally difficult to control the polarization state of radiation passing through the optical system.

SUMMARY OF THE INVENTION

It is an object of the invention to provide a projection objective for microlithography suitable for use in the very deep ultraviolet (VUV) range, where a long-term stability of performance can be maintained in operation.

As a solution to these and other objects the invention, according to one formulation, provides a catadioptric projection objective comprising:

a plurality of optical elements arranged to image an object field arranged in an object surface onto an image field arranged in an image surface of the projection objective without pupil obscuration, the optical elements forming:

a first, refractive objective part generating a first intermediate image from radiation coming from the object surface and including a first pupil surface; and
an imaging subsystem immediately following the first objective part configured to image the first intermediate image onto the image surface;

wherein optical elements arranged between the object surface and the first pupil surface form a Fourier lens group configured to produce a chief ray angle $CRA_{P1}<25°$ at the first pupil surface.

The imaging subsystem designed to image the first intermediate image onto the image surface may be a purely refractive subsystem or a catadioptric subsystem. Where the imaging subsystem is purely refractive, the entire projection objective is a refractive projection objective i.e. an optical system where substantially all optical powers are provided by refractive optical elements (lenses). The imaging subsystem may be a catadioptric subsystem having at least one mirror providing a substantial amount of optical power, such as a concave mirror providing positive optical power. It is not excluded that the projection objective may have one ore more planar folding mirrors for folding the beam path through the system.

The imaging subsystem may be designed to image the first intermediate image onto the image surface directly, i.e. without creating additional intermediate images. In such case, the projection objective will have a single real intermediate image (first intermediate image). In other embodiments the imaging subsystem includes at least two cascaded (or concatenated) imaging objective parts, such that the projection objective includes two ore more real intermediate images.

According to a first aspect of the invention the chief ray angle included between the chief ray and the optical axis at the first pupil surface is relatively small when compared to conventional unobscured systems with similar image-side NA and reduction ratio. For example, the maximum chief ray angle may be less than 22° or less than 20°. For the purpose of this application, the term "chief ray" (also known as principal ray) denotes a ray running from an outermost field point (farthest away from the optical axis) of an effectively used object field to the center of the entrance pupil for a given NA.

Relatively small chief ray angles at the first pupil surface may be generated by providing a Fourier lens group having relatively small overall refractive power when compared to conventional systems, which may be expressed by a relatively large focal length $f_{FLG}$ of the Fourier lens group. In some embodiments the Fourier lens group has a focal length $f_{FLG}$, the projection objective has a distance L (track length) between object surface and image surface, and the condition $|f_{FLG}/L| > 0.08$ holds. Preferably, $|f_{FLG}/L| > 0.10$ and/or $|f_{FLG}/L| > 0.15$.

It has been found that critical perturbations degrading the imaging quality of the projection objective may be efficiently corrected in a targeted fashion if the design is optimized to obtain relatively small chief ray angles at the first pupil surface. For example, various time-dependent radiation-induced changes in the properties of optical materials within the projection system, such as effects caused by lens heating and compaction, induce characteristic contributions to imaging aberrations which are more or less constant across the utilized field. Those aberrations are denoted "field-constant aberrations" in this application. A correction of those essentially field-constant aberrations is particularly effective if the radiation is influenced in a region at or optically near to a pupil surface. If the radiation at the pupil surface is sufficiently corrected across the entire field, a correcting effect essentially constant across the field (field-constant correction) may be obtained if all ray bundles originating from different field points transit the pupil surface at relatively small angles relative to the optical axis of the projection objective.

If the chief ray angle at a pupil surface is too large, geometric projection effects may cause a correcting effect to vary significantly across the field, thereby deteriorating the imaging quality. For example, consider an essentially plane-parallel plate having an aspheric deformation on one surface. The aspheric surface may be described using the local sagitta p(x,y), where x, y are the local coordinates on the element in directions perpendicular to the optical axis. A ray transitting the plate perpendicularly (parallel to the optical axis) is effected by the plate on a geometrical length p(x, y,). However, if the ray transits the plate at an angle $\alpha$ with respect to the perpendicular direction, the effective geometrical length, given by $p(x,y)/\cos(\alpha)$, is enlarged. Likewise, the optical effect is enlarged by this factor. Therefore, If the angle $\alpha$ varies strongly with the field angle, a large field dependency of the correcting effect is expected. Therefore, large chief ray angles should be avoided at a pupil surface used for correction purposes.

Considering correction elements influencing the polarization state of the transiting radiation it is to be noted that a polarizing effect of typical polarizing elements generally depend strongly on the direction of rays in the polarizing element. Therefore, a large variation of ray angles may cause variations of the correcting effect across the field. On the other hand, if the chief ray angle is small, the variation of the polarization-correcting effect across the field can generally be kept below a critical threshold value.

Although a correction at any other pupil surface optically conjugated to the first pupil surface may be possible, the first pupil surface has been found to be particularly suited for correction purpose since other pupil surfaces may not be accessible for placing a correcting element. For example, the third pupil surface formed in a focusing third objective part immediately upstream of the image surface may be formed in a region of large lens density which makes it difficult to place or introduce a correcting element. Further, an aperture stop (fixed or variable) for defining the utilized image-side numerical aperture is frequently arranged in that position. A pupil surface close to a concave mirror may be inaccessible for correction purposes.

Another beneficial effect of relatively small chief ray angles in a pupil surface regards the axial extension of a region which is considered as being "optically close to a pupil surface". The geometrical space optically close to a pupil surface is denoted as "pupil space" in this application. The chief ray angle of the imaging process between field surfaces (e.g. object surface and first intermediate image) corresponds to the numerical aperture of a corresponding pupil imaging between subsequent pupil surfaces. Therefore, the axial extension of the pupil space corresponds to a "depth of focus of the pupil imaging". The extension of the pupil space increases as the chief ray angle becomes smaller. Specifically, the increase or decrease of the "depth focus of the pupil imaging" is proportional to the square of the chief ray angle in the pupil position.

For the purpose of this application the pupil space is defined as a region where the marginal ray height MRH is substantially greater than the chief ray height CRH such that the condition RHR < | B | << 1 is fulfilled for the ray height ratio RHR = | CRH/MRH |. The upper limit B of the ray height ratio may be smaller than 0.4 or smaller than 0.3 or smaller than 0.2, for example, such that at least the condition |RHR|< 0.4 may be fulfilled. If this condition is fulfilled, a correction applied in the pupil space will have an essentially field-constant effect. The axial extension of the pupil space is increased as the chief ray angle at the respective pupil is reduced.

A region considered optically close to pupil surface will have a larger axial extension the smaller the chief ray angle is. A larger region "optically close to a pupil surface" allows more degrees of freedom to place one or more correcting elements sufficiently close to pupil surface to obtain an essentially field-constant correcting effect.

In some embodiments the pupil space includes at least one axial position where a free space defined between mutually facing optical surfaces of optical elements upstream and downstream of the axial position is at least 10mm, where the free space is defined as an axial distance between reference planes orthogonal to the optical axis and touching the optical surfaces upstream and downstream of the axial position. If this condition is fulfilled, at least one correcting element may be inserted into the optical path in the free space such that the correcting element is positioned optically close to the pupil surface. In some embodiments, the free space is at least 20mm or at least 40mm. Although the free space normally includes the position of the pupil surface, it is possible that at least one lens is positioned between the pupil surface and the free space.

In an optical imaging system, the product of the paraxial chief ray angle and the size of a pupil is a constant (Lagrange invariant). Therefore, a small chief ray angle at the first pupil surface corresponds to a relatively large size of the first pupil, i.e. to relatively large beam diameters of the beam at the first pupil surface. In some embodiments, a radiation beam between the object surface and the image surface at a given numerical aperture NA defines a first optical free diameter $D_1$ in the first pupil surface and a third optical free diameter $D_3$ in the third pupil surface, wherein a diameter ratio $D_1/D_3$ fulfills the condition: $1/A < D_1/D_3 < A$, where $A = 2$. With other words, the sizes of the third pupil surface (closest pupil surface to the image surface) and the first pupil surface (closest pupil surface to the object surface) are relatively similar and do not differ as much as in prior art systems having comparable NA.

In some embodiments, a size of the first pupil obeys the condition: $MRH_{P1}/k_{CR} > 160$, where $MRH_{P1}$ is a marginal ray height at a first pupil surface (in mm) and $k_{CR}$ is a direction cosine of the chief ray of an outermost field point (in mrad). According to the Lagrange invariant $L = MRH_{P1} * k_{CR} = constant$, the parameter $MRH_{P1}/k_{CR}$ scales quadratically with the marginal ray height $MRH_{P1}$ at the first pupil surface. The direction cosine $k_{CR}$ of the chief ray is the cosine of the angle included between the chief ray and a y-direction perpendicular to the optical axis (z-direction). Specifically, $k_{CR}$ corresponds to the sine of the angle CRA included between the chief ray and the optical axis multiplied with the refractive index n at the position of the first pupil according to $k_{CR} = n*sin(CRA)$.

The parameter $MRH_{P1}/k_{CR}$ may be larger than 160 or larger than 180 or larger than 200, for example.

If the condition $MRH_{P1}/k_{CR} > 160$ is fulfilled, advantageous properties in the region of the first pupil (relatively large pupil size, possibility to effect an essentially field-constant correction) may be obtained in catadioptric projection objectives having at least one intermediate image irrespective of whether or not a pupil obscuration exists. Therefore, according to another formulation the invention provides a catadioptric projection objective comprising:

a plurality of optical elements arranged to image an object field arranged in an object surface onto an image field arranged in an image surface of the projection objective, the optical elements forming:

a first, refractive objective part generating a first intermediate image from radiation coming from the object surface and including a first pupil surface; and
an imaging subsystem immediately following the first objective part configured to image the first intermediate image onto the image surface;

wherein a size of a first pupil at the first pupil surface obeys the condition: $MRH_{P1}/k_{CR} > 160$, where $MRH_{P1}$ is a marginal ray height at the first pupil surface and $k_{CR}$ is a direction cosine of the chief ray of an outermost field point.

A relatively large pupil size may be beneficial if an aperture stop is positioned at the respective pupil, as the specification of the aperture stop at the largest free diameter of the aperture may be relaxed because variations of the absolute size of the aperture diameter have only relatively small effects on the relative variation of the size of the free diameter. Therefore, a desired size of the utilized free diameter of the aperture may be adjusted precisely. In some embodiments, an aperture stop is positioned at the first pupil surface. The aperture stop may be a variable aperture stop allowing to adjust the size of the free diameter of the aperture and, thereby, allowing to adjust the utilized image-side numerical aperture NA.

Also, where the pupil size is relatively large, a correcting element placed at some distance outside the exact pupil position will still have essentially the same effect on all ray bundles originating from different field points since the sub-apertures of ray bundles originating from different field points still overlap considerably at a small distance from the exact pupil position if the size of the pupil is large.

In some embodiments the projection objective comprises at least one correcting element configured to be inserted into or inserted in a pupil space at or optically close to the first pupil surface. The correcting element may be an optical element provided in addition to the optical elements of the original design of the projection objective, where the correcting element should be designed to have only relatively small effect on the optical performance. In most cases the correcting element may be formed by an optical element which is part of the original design of the projection objective and may be slightly modified to obtain a slightly different optical effect as desired for correction purposes. An exchanging device operatively coupled to the at least one correcting element may be provided and configured to optionally insert the correcting element into the beam path or remove the correcting element out of the beam path as desired, or to replace an optical element of the optical design by a correcting element formed by a corresponding optical element having slight modifications with respect to the original optical element.

As the region optically close to the pupil surface may be relatively large, in some embodiments, a first correcting element and at least one second correcting element, both configured to be inserted into the pupil space or inserted in the pupil space may be provided. For example, one correcting element may be a transparent polarization element influencing the polarization state of radiation transiting the polarization element, and the other correcting element may be a refractive correcting element having a predefined spatial distribution of refractive power. For example, such correcting element may be essentially formed like a plane parallel plate inserted orthogonal to the optical axis where at least one surface of the plate is shaped as a rotationally symmetric or as a freeform (non-rotationally symmetric) aspheric surface to obtain a desired spatial distribution of refractive power. Also, at least one correcting element may be a transmission filter element having a transmission locally varying across a utilized diameter of the filter element in order to modify the intensity distribution across the beam diameter at or optically close to the first pupil surface. If an exchanging device operatively coupled to at least one correcting element is provided to optionally insert a correcting element into the beam path or remove the correcting element from the beam path, a dynamical correction of imaging properties of the projection objective is possible at the location of use of the projection objective depending on the time-scale of perturbation to be corrected.

According to another aspect the invention relates to a method of fabricating semiconductor devices and other types of microdevices utilizing a projection objective comprising a plurality of optical elements arranged to image an object field arranged in an object surface onto an image field arranged in an image surface of the projection objective, the optical elements forming:

a first, refractive objective part generating a first intermediate image from radiation coming from the object surface and including a first pupil surface; and
an imaging subsystem immediately following the first objective part configured to image the first intermediate image onto the image surface;
placing a mask providing a prescribed pattern in the object surface of the projection objective;
illuminating the mask with ultraviolet radiation having a prescribed wavelength;
projecting an image of the pattern onto the photosensitive substrate; and
adjusting the imaging characteristics of the projection objective by inserting at least one correcting element into a pupil space or removing a correcting element from the pupil space at the first pupil surface.

The method may be performed on projection objectives having off-axis object field and image field and no pupil obscuration, but may also be utilized in systems having a pupil obscuration.

The adjusting step may be performed at the location of use of the projection objective during an exchange of substrates and/or during an exchange between different masks and/or during a change between different illumination settings.

The step of adjusting the imaging characteristics of the projection objective may be performed by inserting at least two correcting elements into a pupil space or removing one or more of at least two correcting elements from the pupil space at the first pupil surface. More degrees of freedom for correction are thereby obtained. One correcting element may be an aspheric correcting element acting predominantly on a spatial distribution of refracting power, whereas another correcting element may be a polarization influencing element acting predominantly on the polarization state within the projection beam.

As some of the aberrations which may be corrected by using at least one correcting element optically near to a pupil surface may be dynamic effects on a relative short time scale, it may be provided that imaging aberrations (or other properties influencing imaging aberrations) associated with time-dependent variations of optical properties of the projection system are detected (or sensed) by an appropriate detector generating sensing signal indicative of that time-dependent changes, and at least one correcting element may be introduced into a pupil space or removed from the pupil space to compensate at least partly the time-dependent changes. The exchanging device may thereby be integrated into a control loop allowing real-time control of imaging aberrations by exchanging at last one correcting element.

Alternatively, or in addition, a feed-forward control of the correcting influence may be utilized to optionally insert at least one correcting element into the beam path or remove a correcting element from the beam path in response to control signals based on look-up tables or the like.

Alternatively, or in addition, an element or a number of elements whose surface shape may be dynamically modified and/or whose positions relative to each other may be dynamically changed may be inserted into the beam path. Therefore, at least one correcting element may be an active correcting element having a variable structure configured to be varied to obtain a variable optical correction effect. In that case, correction may be performed dynamically during operation or use of the projection objective. Active optical elements or arrangements suitable for that purposes are disclosed, for example in US 6,504597 B2, US 5,805,273 or US 6,104, 472.

The invention also relates to a projection exposure apparatus comprising:

a light source generating primary radiation;
an illumination system forming the primary radiation to generate illumination radiation incident on a mask bearing a pattern; and
a projection objective projecting an image of the pattern onto a radiation-sensitive substrate, the projection objective comprising a plurality of optical elements arranged to image an object field arranged in an object surface onto an image field arranged in an image surface of the projection objective, the optical elements forming:

a first, refractive objective part generating a first intermediate image from radiation coming from the object surface and including a first pupil surface; and
an imaging subsystem immediately following the first objective part configured to image the first intermediate image onto the image surface;
an exchanging device configured to insert at least one correcting element into a pupil space or removing a correcting element from the pupil space at the first pupil surface.

The exchanging device may be configured to insert at least two correcting elements into the pupil space or removing one or more of at least two correcting elements from the pupil space at the first pupil surface.

The invention may be incorporated into different types of projection objectives.

For example, the projection objective may be a purely refractive projection objective having a first objective part generating a first real intermediate image, which is the only intermediate image of the projection objective. An on-axis object field and image field (object field and image field centered around the optical axis) may be utilized in those cases. For this purpose, embodiments as generally outlined in US 2006/0056064 A1 may be modified to provide the preferred conditions around the first pupil surface.

Embodiments of catadioptric projection objectives (including at least one curved mirror) may also be used. At least one curved mirror may be a concave mirror. Where a physical beam splitter is used to separate radiation guided towards a concave mirror and reflected from a concave mirror an on-axis object field and image field can be used. Where fully reflecting planar folding mirrors are used to separate radiation guided towards and reflected from a concave mirror, an off-axis object field and image field (all field points outside the optical axis at a distance therefrom) is typically used if vignetting and pupil obscuration shall be avoided.

In some embodiments of catadioptric projection objectives the imaging subsystem immediately following the first objective part configured to image the first intermediate image onto the image surface comprises; a second objective part including at least one concave mirror imaging the first intermediate image into a second intermediate image and including a second pupil surface optically conjugated to the first pupil surface; and
a third, refractive objective part imaging the second intermediate image onto the image surface and including a third pupil surface optically conjugated to the first and second pupil surface;

In some embodiments utilizing an off-axis object field and image field, the projection objective is a catadioptric projection objective designed as an "in-line-system" i.e. as a catadioptric projection objective having one straight (unfolded) optical axis common to all optical elements of the projection objective. From an optical point of view, in-line systems may be favorable since optical problems caused by utilizing planar folding mirrors, such as polarization effects or image-flip, can largely be avoided. Also from a manufacturing point of view, in-line systems may be designed such that conventional mounting techniques for optical elements can be utilized, thereby improving mechanical stability, of the projection objective.

In some embodiments the second objective part has a mirror group having an object-side mirror group entry for receiving radiation coming from the object surface and an image-side mirror group exit for exiting radiation emerging from the mirror group exit towards the image surface, where the mirror group includes an even number of concave mirrors. In some embodiments, the second objective part has exactly two concave mirrors. The second objective part may be catadioptric (including at least one transparent lens in addition to at least one concave mirror) or catoptric (having only mirrors). In some embodiments capable of providing an obscuration free imaging without vignetting at very high image-side numerical apertures NA>1 all concave mirrors of the mirror group are optically remote from a pupil surface.

In other embodiments, a second objective part has exactly one concave mirror. A first folding mirror is provided for deflecting the radiation coming from the object surface in the direction of the concave mirror and a second folding mirror is provided for deflecting the radiation coming from the concave mirror in the direction of the image surface. In those embodiments, the final intermediate image (intermediate image closest to the image surface) may be positioned relatively close to the second reflecting mirror optically upstream or downstream thereof depending on design.

It is contemplated that the invention may be implemented in projection objectives for dry lithography at NA < 1 as well as in projection objectives for immersion lithography at NA ≥ 1. Typical embodiments may have NA ≥ 0.80 and/or NA ≥ 0.90, for example.

The previous and other properties can be seen not only in the claims but also in the description and the drawings, wherein individual characteristics may be used either alone or in sub-combinations as an embodiment of the invention and in other areas and may individually represent advantageous and patentable embodiments.

BRIEF DESCRIPTION OF THE DRAWINGS

Fig. 1    is a meridional section of a first embodiment of a projection objective according to the invention, and Fig. 1A shows a detail therefrom;

Fig. 2    is a meridional section of a second embodiment of a projection objective according to the invention;

Fig. 3    is a meridional section of a third embodiment of a projection objective according to the invention;

Fig. 4    shows a schematic drawing of a projection exposure apparatus for microlithography having an illumination system and a projection objective according to an embodiment of the invention

DETAILED DESCRIPTION OF THE PREFERRED EMBODIMENTS

In the following description of preferred embodiments, the object involved is a mask (reticle) bearing the pattern of a layer of an integrated circuit or some other pattern, for example, a grating pattern. The image of the object is projected onto a wafer serving as a substrate that is coated with a layer of photoresist, although other types of substrates, such as components of liquid-crystal displays or substrates for optical gratings, are also feasible.

Where tables are provided to disclose the specification of a design shown in a figure, the table or tables are designated by the same numbers as the respective figures. Corresponding features in the figures are designated with like or identical reference identifications to facilitate understanding. Where lenses are designated, an identification L3-2 denotes the second lens in the third objective part (when viewed in the light propagation direction.

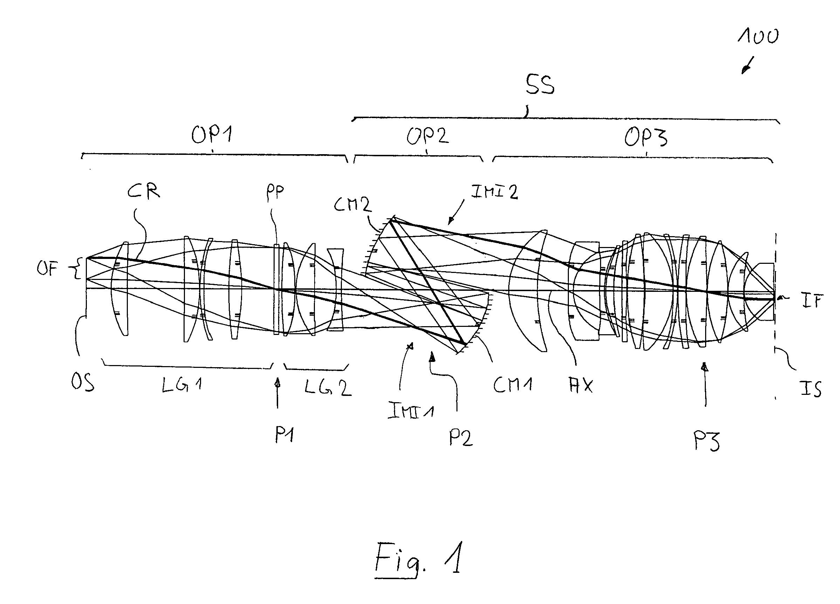

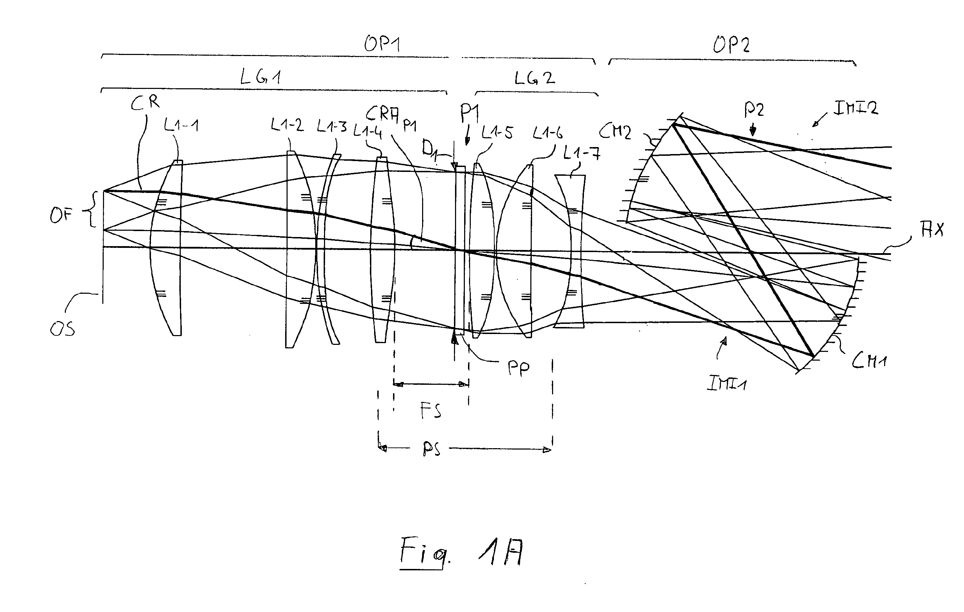

Fig. 1 shows a first embodiment of a catadioptric projection objective 100 designed for ca. $\lambda \approx 193$ nm UV operating wavelength. It is designed to project an image of a pattern on a reticle arranged in the planar object surface OS (object plane) into the planar image surface IS (image plane) on a reduced scale, for example, 4:1, while creating exactly two real intermediate images IM11, IM12. The effective object field OF and image field IF are off-axis, i.e. entirely outside the optical axis AX. A first refractive objective part OP1 is designed for imaging the pattern in the object surface into the first intermediate image IMI1 at an enlarged scale. A second, catoptric (purely reflective) objective part OP2 images the first intermediate image IMI1 into the second intermediate image IMI2 at a magnification close to 1:(-1). A third, refractive objective part OP3 images the second intermediate image IMI2 onto the image surface IS with a strong reduction ratio. The second and third objective parts OP2 and OP3 form an imaging subsystem SS (including the second intermediate image), which immedeately follows the first objective part OP1 and which is configured to image the first intermediate image IMI1 into the image surfaces creating an additional intermediate image (second intermediate image IMI2).

Fig. 1A shows an enlarged view of the first and second objective part.

The path of the chief ray CR of an outer field point of the off-axis object field OF is drawn bold in Fig. 1 and 1A in order to facilitate following the beam path of the projection beam. For the purpose of this application, the term "chief ray" (also known as principal ray) denotes a ray running from an outermost field point (farthest away from the optical axis) of the effectively used object field OF to the center of the entrance pupil. Due to the rotational symmetry of the system the chief ray may be chosen from an equivalent field point in the meridional plane as shown in the figures for demonstration purposes. In projection objectives being essentially telecentric on the object side, the chief ray emanates from the object surface parallel or at a very small angle with respect to the optical axis. The imaging process is further characterized by the trajectory of marginal rays. A "marginal ray" as used herein is a ray running from an axial object field point (field point on the optical axis) to the edge of an aperture stop. That marginal ray may not contribute to image formation due to vignetting when an off-axis effective object field is used. The chief ray and marginal ray are chosen to characterize optical properties of the projection objectives. The angles included between such selected rays and the optical axis at a given axial position are denoted as "chief ray angle" (CRA) and "marginal ray angle" (MRA), respectively. The radial distance between such selected rays and the optical axis at a given axial position are denoted as "chief ray height" (CRH) and "marginal ray height" (MRH), respectively.

Three mutually conjugated pupil surfaces P1, P2 and P3 are formed at positions where the chief ray CR intersects the optical axis. A first pupil surface P1 is formed in the first objective part between object surface and first intermediate image, a second pupil surface P2 is formed in the second objective part between first and second intermediate image, and a third pupil surface P3 is formed in the third objective part between second intermediate image and the image surface IS.

The second objective part OP2 comprises a first concave mirror CM1 having the concave mirror surface facing the object side, and a second concave mirror CM2 having the concave mirror surface facing the image side. The used parts of the mirror surfaces are both continuous or unbroken, i.e. the mirrors do not have a hole or bore in the illuminated region. The mirror surfaces facing each other define a catadioptric cavity, which is also denoted intermirror space, enclosed by the curved surfaces defined by the concave mirrors. The intermediate images IMI1, IM12 are both situated inside the catadioptric cavity well apart from the mirror surfaces.

The objective 100 is rotational symmetric and has one straight optical axis AX common to all refractive and reflective optical components ("In-line system"). There are no folding mirrors. An even number of reflections occurs. Object surface and image surface are parallel. The concave mirrors have small diameters allowing to bring them close together and rather close to the intermediate images lying in between. The concave mirrors are both constructed and illuminated as off-axis sections of axial symmetric surfaces. The light beam passes by the edges of the concave mirrors facing the optical axis without vignetting. Both concave mirrors are positioned optically remote from a pupil surface rather close to the next intermediate image. The objective has an unobscured circular pupil centered around the optical axis thus allowing use as projection objectives for microlithography.

The projection objective 100 is designed as an immersion objective for $\lambda$ = 193 nm having an image side numerical aperture NA = 1.55 when used in conjunction with a high index immersion fluid, e.g. cyclohexane, between the exit surface of the objective and the image surface. The projection objective is designed for a rectangular 26 mm * 5.5 mm field and is corrected for a design object field having object field radius (object height) 67 mm. The track length (axial distance between object surface and image surface) is about 1400 mm.

The specification for this design is summarized in Table 1. The leftmost column lists the number of the refractive, reflective, or otherwise designated surface, the second column lists the radius, r, of that surface [mm], the third column lists the distance, d [mm], between that surface and the next surface, a parameter that is referred to as the "thickness" of the optical element, the fourth column lists the material employed for fabricating that optical element, and the fifth column lists the refractive index of the material employed for its fabrication. The sixth column lists the optically utilizable, clear, semi diameter [mm] of the optical component. A radius r = 0 in a table designates a planar surface (having infinite radius).

A number of surfaces are aspherical surfaces. Table 1A lists the associated data for those aspherical surfaces, from which the sagitta or rising height p(h) of their surface figures as a function of the height h may be computed employing the following equation:

$$p(h) = [((1/r)h^2)/(1 + SQRT(1 - (1 + K)(1/r)^2h^2))] + C1 \cdot h^4 + C2 \cdot h^6 + \ldots ,$$

where the reciprocal value (1/r) of the radius is the curvature of the surface in question at the surface vertex and h is the distance of a point thereon from the optical axis. The sagitta or rising height p(h) thus represents the distance of that point from the vertex of the surface in question, measured along the z-direction, i.e., along the optical axis. The constants K, C1, C2, etc., are listed in Table 1 A.

First objective part OP1 imaging the (rectangular) effective object field OF into the first intermediate image IMI1 may be subdivided into a first lens group LG1 with overall positive refractive power between object surface and first pupil surface P1, and a second lens group LG2 with overall positive refractive power between first pupil surface P1 and the first intermediate image IM11. First lens group LG1 is designed to image the telecentric entrance pupil of the projection objective into first pupil surface P1, thereby acting in the manner of a Fourier lens group performing a single Fourier transformation. This Fourier transformation leads to a relatively small chief ray angle $CRA_{P1}$ in the order of 18° at first pupil surface. As a consequence, the optically free diameter of the first pupil is relatively large. The diameter of the first pupil may be described by the diameter $D_1$ of the radiation beam in the first pupil surface (see arrows) which is about 186 mm in this embodiment.

The first lens group includes, in this order from the object surface, an almost piano-convex positive lens L1-1 with object-side convex aspheric surface, an almost plano-convex positive lens L1-2 with image-side convex aspheric surface, a thin meniscus lens L1-3 with little refractive power and image-side concave aspheric surface and a biconvex positive lens L1-4 aspheric on the exit surface immediately upstream of the first pupil surface. A plane parallel plate PP described in detail below is positioned at the first pupil surface P1 at a position where the condition RHR = 0 applies for the ray height ratio RHR= | CRH/MRH |. The second lens group LG2 includes a biconvex positive lens L1-5 with aspheric exit surface immediately downstream of the first pupil surface, an almost plano-convex positive lens L1-6 with image-side aspheric surface, and a biconcave negative lens L1-7 immediately upstream of the first intermediate image. Second lens goup LG2 is designed to focus radiation coming from the first pupil surfaces into the first intermediate image.

In the enlarged view of the first objective part given in Fig. 1A the chief ray shown in the drawing is the chief ray originating from an outermost field point at a corner of the rectangular effective object field OF (corresponding to an object height OBH = 67 mm) rotated about the optical axis into the meridional plane shown in the figure. Therefore the chief ray angle $CRA_{P1} \approx 18°$ may be taken directly from the figure. Given this relatively small value for the chief ray angle at the first pupil surface P1 an axial region which is considered "optically close to the first pupil surface" has a relatively large axial extension to both sides of the first pupil surface P1. A pupil space PS defined as the region where the amount of the ray height ratio RHR=CRH/MRH between the chief ray height and the marginal ray height is smaller than 0.3 is indicated in Fig. 1A. The pupil space includes the position of the first pupil P1 and includes lens L1-4 on the object-side and lenses L1-5 and L1-6 on the image-side of the pupil surface P1. Any correction applied to the radiation beam in this region will have a substantially similar effect to all field points since the sub-apertures of ray bundles originating from the field points overlap to a substantial amount in this pupil space optically closed to the first pupil surface.

The relatively wide pupil space PS includes a relatively wide free space FS between mutually facing lens surfaces of lenses in the basic design. In the embodiment, the exit surface of positive lens L1-4 and the entry surface of positive L1-5 have an axial distance of about 81 mm, which allows to place one or more correcting elements, such as the parallel plate PP optionally provided with an aspheric surface, optically close to the first pupil surface. In the embodiment, the parallel plate PP is positioned exactly at the first pupil surface. However, any axial position within the free space FS would lead to an essentially field-constant correcting effect of a correcting element, such as a correcting element essentially shaped like the parallel plate PP, where the field variation of the correcting effect is smaller the smaller the distance between the correcting element and the first pupil surface is.

The free space FS is large enough to allow a continuous variation of the axial position of the correcting element substantially in a range from about RHR=0 to about RHR=0.2 or above. Therefore, a certain amount of variation of the correcting effect across the field may intentionally be introduced by positioning the correcting element at an appropriate position within the free space. A displacing device for axially displacing a correction element between different axial positions along the optical axis may be provided to adjust the axial position of the correcting element as desired. If more than one correcting element is used, a relative axial separation between correcting elements may be varied by axially displacing one or more correcting elements within the free space at desired axial positions to obtain a desired overall correcting effect. Therefore, a fine-tuning of the correcting effect by axial displacement of at least one correcting element within the pupil space may be performed.

Considering that the product of the paraxial chief ray angle and the size of pupil is a constant in an optical imaging system (Lagrange invariant), the size of the first pupil, given by the diameter $D_1$ of the radiation beam at the first pupil at maximum NA is relatively large. In the embodiment the diameter $D_1$ is similar to the maximum optically free diameter at any lens in the first objective part OP1. Specifically, $D_1$ may be more than 80% or more than 90% of the largest optically free diameter of optical elements of the first lens group. In the embodiment $D_1$ is about 83% of the optically free diameter of the entry surface of lens L1-2. As evident from Fig. 1 and the corresponding table, the diameter $D_1$ of the first pupil surface is rather similar to the diameter $D_3$ of the third pupil P3 in the focusing lens group (third objective part OP3). In the embodiment, $D_3 = 216$ such that the diameter ratio $D_1/D_3 \approx 0.85$. In many embodiments the condition $1/A < D_1/D_3 < A$ holds, where A = 2.

Some advantages of a large first pupil (corresponding to relatively small chief ray angles at the first pupil) are now explained in more detail, using a correction plate having one aspheric surface for correction of imaging aberrations as an example. The original layout of the projection objective (as provided e.g. by an optics designer) may include a plane parallel plate PP positioned at the first pupil surface. The relatively small optical effect of the plane parallel plate may be incorporated into the original design, which may be optimized including the parallel plate PP. A parallel plate PP may serve as a carrier element for an aspheric surface, which may be useful lateron to correct imaging aberrations occurring upon operation of the projection objective. A correcting element having the same general properties as the parallel plate (i.e. same thickness and material) may be provided to replace the (ideal) plane-parallel plate as desired. One surface (or both surfaces) of the correcting element may be shaped as an aspheric surface to provide a defined spatial distribution of refractive power different from that of an ideal plane parallel plate. The (ideal) plane parallel plate may be removed out of the beam path and the correcting element may be inserted into the beam path at a given time during the lifetime of the projection objective to compensate for deteriorations of the imaging quality which occurred upon prolonged use of the projection objective.

In the embodiment, the parallel plate PP may be designed as a correction plate by shaping at least one of the plate surfaces as an aspheric surface, which may be rotationally symmetric to the optical axis or may be a freeform surface (without rotational symmetry to the optical axis) as desired.

Placing such correcting element at or optically close to a large pupil (in a region of small chief ray angles) allows to keep geometric projection effects small. This may be understood as follows. If an aspheric deformation is applied to an optical surface and if, for simplicity, it is assumed that an axial ray bundle incident on the aspheric surface is essentially collimated (all rays of the ray bundle are essentially parallel to each other at the aspheric surface), then the rising height (sagitta) of the correcting surface is transformed onto a change at the wavefront of the transitting radiation with a factor $n-1$, wherein $n$ is the refractive index of the optical element having the aspheric surface. Typically, $n$ is in the order of 1.5 such that a wavefront correction of $p/2$ is obtained at a value $p$ of the sagitta. Considering now an axial ray bundle which transits the correcting element as an essentially collimated ray bundle obliquely with an angle $\alpha$ included between the rays and the optical axis. In this case the correcting effect will be different since the geometrical beam path in the correcting element is larger. As a consequence, the correcting effect will become field dependent as a result of such geometrical projection effects. Further, considering that an aspheric correcting surface includes gradients of the surface shape, additional higher order aberrations may be caused. For example, if a correcting asphere is designed to cause (and thereby correct) spherical aberration, additional coma terms may be generated in the field. The projection effects explained above are substantially influenced by the finite angle of the ray bundles to the optical axis, which may be represented by the respective chief ray angle CRA. Therefore it is desireable that the chief ray angle at a position of a correcting ashpere should be as small as possible. Typically, for a projection objective having NA > 0.6 the condition $n * \sin(CRA) < 0.3$ should be observed.

If the applied corrections are desired to be essentially field-constant (essentially the same for all field points) it is desirable to place the correcting element as close as possible to a pupil surface. This is due to the fact that the rays of each ray bundle originating from different field points fill the entire pupil and the sub-apertures of ray bundles originating from different field points overlap to the largest extent in a pupil surface. The amount of overlap between sub-apertures of different field points becomes smaller the larger the distance to the next pupil surface is. As the distance between a position and the next pupil surface increases, the overlap between different sub-apertures decreases as the sub-apertures become more and more separated in a lateral direction. If the distance to the pupil surface exceeds a certain limiting value, then the sub-aperture corresponding to an axial field point and a sub-aperture corresponding to a field point at maximum field height are completely separated and a correcting effect substantially similar for both ray bundles cannot be effected. Therefore a correcting element should be placed at or optically near to a pupil surface if a correcting effect with little variation across the field is desired. In preferred embodiments, the pupil space selected for inserting one or more correcting elements is defined as a region where the chief ray height CRH does not exceed 30% of the marginal ray height MRH (such that RHR < 0.3).

The axial extension of the region around the pupil suitable for applying essentially field-constant corrections depends on the chief ray angle and the marginal ray height and may be described by the ratio $| MRH/(n*\sin(CRA)) |$ where $n$ is the refractive index in the region where the angle CRA is measured. This may be an air space around a correcting element, or the interior of a transparent correcting element. The larger the value of parameter $| MRH/(n*\sin(CRA)) |$ becomes, the larger is the axial extension of this pupil space in which a correcting element can be placed at different axial position and still may exert a correcting effect essentially constant across the field. This condition may apply for object fields of different diameter, characterized for example by a maximum object height OBH. It has been found that in many cases where an off-axis field is used, a suitable axial space around the pupil is provided to apply an essentially field-constant correction if the condition $| MRH/(n*\sin(CRA)) |/OBH>2.6$ is fulfilled. Preferably, $|MRH/(n*\sin(CRA)) |/OBH>2.8$ or $|MRH/(n*\sin(CRA)) |/OBH>3.0$ should apply.

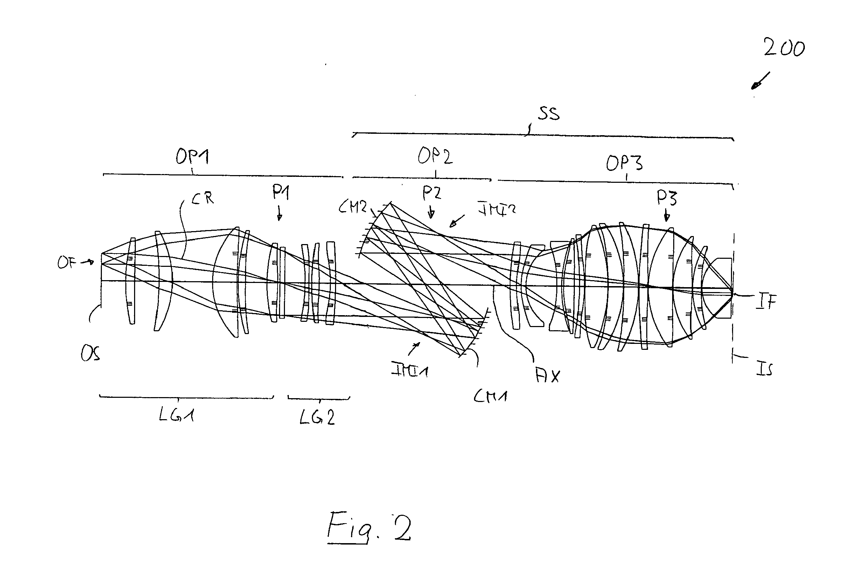

A second embodiment of a catadioptric projection objective 200 is shown in Fig. 2. Corresponding features are designated with the same reference designations as in Fig. 1. The specification of the third embodiment is given in tables 2, 2A. This embodiment is designed for an annular field (ring field) having similar width (26mm) and height (5.5mm) as in the previous embodiments. Due to the arcuate shape of the field vignetting control at the second concave mirror is facilitated. When an arcuate field is used, the footprint on second concave mirror M2 optically close to the next field surface (second intermediate image IM12) is partially formed around the footprint of the radiation beam passing second concave mirror M2, which is optically closer to a pupil surface (first pupil surface). Reference is made to applicant's application US 2005/0190435 for detailed information about the general shapes of footprints of the radiation beam in two-mirror in-line catadioptric systems of the general construction given in the first to third embodiment of this application. Corresponding disclosure is incorporated herein by reference. By using an arcuate field it is possible to have a shorter track length, which is about 1300mm in the embodiment of Fig. 2. Therefore, the comparison between the embodiments teaches that using an arcuate shaped ring field instead of a rectangular field may allow to reduce the overall axial length of in-line projection objective of this general construction.

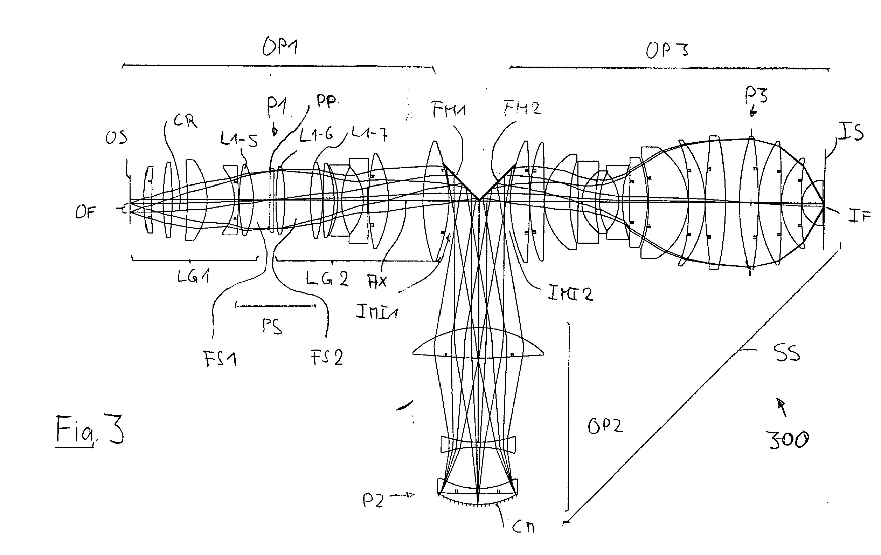

Fig. 3 shows a third embodiment of a catadioptric projection objective 300 designed for ca. $\lambda \approx 193$ nm UV operating wavelength. Corresponding features are designated with the same reference designations as in Fig. 1. The specification of the fourth embodiment is given in tables 3, 3A. Projection objective 300 is designed to project an image of a pattern on a reticle arranged in the planar object surface OS (object plane) into the planar image surface IS (image plane) on a reduced scale, for example, 4:1, while creating exactly two real intermediate images IM11, IM12. The rectangular effective object field OF and image field IF are off-axis, i.e. entirely outside the optical axis AX. A first refractive objective part OP1 is designed for imaging the pattern in the object surface into the first intermediate image IM11 at an enlarged scale. A second, catadioptric (refractive/reflective) objective part OP2 images the first intermediate image IMI1 into the second intermediate image IMI2 at a magnification close to 1:(-1). A third, refractive objective part OP3 images the second intermediate image IMI2 onto the image surface IS with a strong reduction ratio.

Three mutually conjugated pupil surfaces P1, P2 and P3 are formed at positions where the chief ray CR intersects the optical axis. A first pupil surface P1 is formed in the first objective part between object surface and first intermediate image, a second pupil surface P2 is formed in the second objective part between first and second intermediate image, and a third pupil surface P3 is formed in the third objective part between second intermediate image and the image surface IS.

The second objective part OP2 includes a single concave mirror CM. A first planar folding mirror FM1 is arranged optically close to the first intermediate image IMI1 at an angle of 45° to the optical axis AX such that it reflects the radiation coming from the object surface in the direction of the concave mirror CM. A second folding mirror FM2, having a planar mirror surface aligned at right angles to the planar mirror surface of the first folding mirror, reflects the radiation coming from the concave mirror CM in the direction of the image surface, which is parallel to the object surface.

The folding mirrors FM1, FM2 are each located in the optical vicinity of an intermediate image, so that the etendue (geometrical flux) is kept small. The intermediate images are preferably not located on the planar mirror surfaces, which results in a finite minimum distance between the intermediate image and the optically closest mirror surface. This is to ensure that any faults in the mirror surface, such as scratches or impurities, are not imaged sharply onto the image surface.

The first objective part OP1 comprises two lens groups LG1, LG2 each with positive refractive power on either side of the first pupil surface P1. First lens group LG1 is designed to image the telecentric entrance pupil of the projection objective into the first pupil surface P1, thereby acting in the manner of a Fourier lens group performing a single Fourier transformation. This Fourier transformation leads to a relatively small maximum chief ray angle $CRA_{P1}$ in the order of 17° at the first pupil surface. As a consequence, according to the Lagrange invariant, the optically free diameter of the first pupil is relatively large, indicated by a diameter $D_1$=145mm of the radiation beam in the first pupil surface. The relatively small chief ray angle along with the large pupil diameter corresponds to a relatively large axial extension of the pupil space PS where the condition RHR < 0.3 is fulfilled. In the embodiment, the pupil space PS includes the first lens L1-6 of LG2 immediately downstream of the pupil surface (biconvex lens) and extends up to the subsequent lens L1-7 on the image-side of the pupil surface and up to the biconvex positive lens L1-5 immediatley upstream of the first pupil surface. Free spaces FS1 (=41 mm) and FS2 (=62mm), each having an axial extension of at least 40 mm allowing to place one or more thin correcting elements into the free space are formed on either side of the pupil surface P1 within the pupil space PS, i.e. optically close to the pupil surface. Therefore, this embodiment allows introducing one or more correcting elements optically close to the first pupil surface P1 in order to obtain correcting effects which are essentially the same for all field points of the field (field-constant correction).

A parallel plate PP is positioned in the pupil space PS at the first pupil surface P1 where the condition RHR $\approx$ 0 is fulfilled. As described earlier, the parallel plate is part of the original design of the projection objective and may serve as a placeholder for a correcting element which may also be formed essentially as a plane parallel plate having the same thickness and material, where at least one surface has an aspheric shape.

Table 4 shows some values for characteristic parameters discussed above for the embodiments in Figs. 1 to 3.

**Table 4**

| | NA | OBH [mm] | $n*\sin(CRA) = k_{CR}$ | MRH/ $k_{CR}$ | MRH/ ($k_{CR} * OBH$) | $f_{FLG}$ /L |
|---|---|---|---|---|---|---|
| **Fig. 1** | 1,55 | 67,00 | 0,309 | 306 | 4,57 | 0.153 |
| **Fig. 2** | 1,55 | 56,00 | 0,327 | 204 | 3,64 | 0.129 |
| **Fig. 3** | 1,35 | 61,00 | 0,300 | 246 | 4,03 | 0.117 |

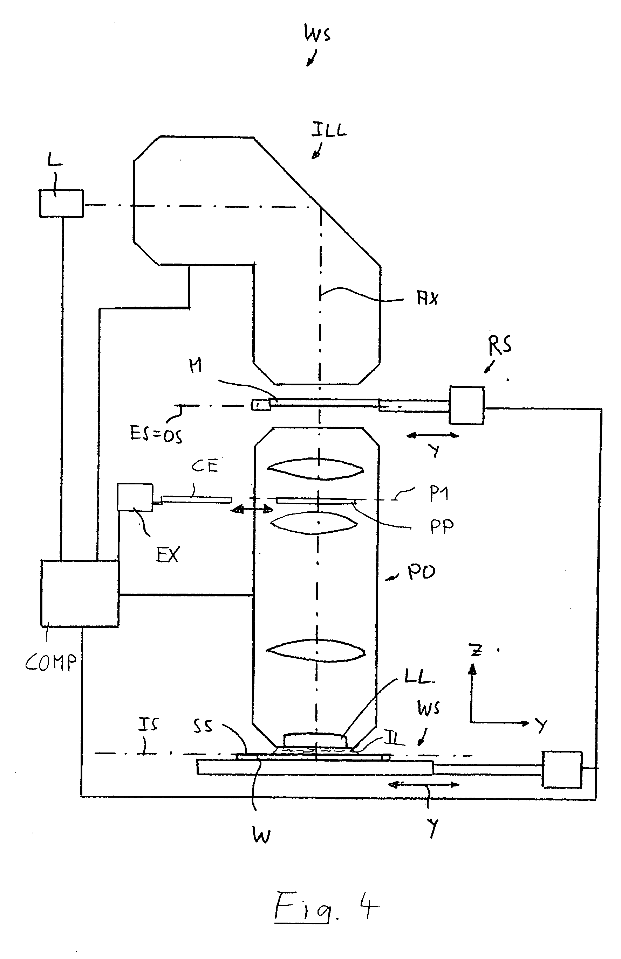

Fig. 4 shows schematically a microlithographic projection exposure apparatus in the form of a wafer scanner WS, which is provided for fabricating large scale integrated semiconductor components in a step-and-scan mode. The projection exposure apparatus comprises as light source an ArF excimer laser L having an operating wavelength of about 193 nm. Other operating wavelengths are also possible in other embodiments. A downstream illumination system ILL generates, in its exit surface ES, a large, sharply delimited, homogeneously illuminated illumination field that is adapted to the telecentric requirements of the downstream catadioptric projection objective PO. The illumination system ILL has devices for selection of the illumination mode and, in the example, can be changed over between conventional on-axis illumination with a variable degree of coherence, and off-axis illumination, particularly annular illumination (having a ring shaped illuminated area in a pupil surface of the illumination system) and dipole or quadrupole illumination.

Arranged downstream of the illumination system is a device RS (reticle stage) for holding and manipulating a mask M in such a way that a pattern formed on the mask lies in the exit surface ES of the illumination system coinciding with the object surface OS of the projection objective PO and can be moved in this plane for a scanning operation in a scanning direction (Y-direction) perpendicular to the optical axis AX common to the illumination system and the projection objective (i.e. the Z-direction).

The reduction projection objective PO is designed to image an image of a pattern provided by the mask with a reduced scale of 4:1 (magnification ratio |ß| = 0.25) onto a wafer W coated with a photoresist layer. The wafer W serving as a light-sensitive substrate is arranged in such a way that the planar substrate surface SS with the photoresist layer essentially coincides with the planar image surface IS of the projection objective. The wafer is held by a device WS (wafer stage) comprising a scanner drive in order to move the wafer synchronously with the mask M in parallel with the latter. The device WS also comprises manipulators in order to move the wafer both in the Z direction parallel to the optical axis and in the X and Y directions perpendicular to said axis. A tilting device having at least one tilting axis running perpendicular to the optical axis is integrated.

The projection objective PO has a flat, planoconvex last lens LL as the last optical element nearest to the image surface IS, the planar exit surface of said last lens being the last optical surface (exit surface) of the projection objective PO.

The exposure apparatus is configured for immersion lithography and includes an immersion medium guiding system (not shown) to guide a transparent, high index immersion liquid IL into a small gap between the exit surface of the projection objective and the substrate such that the immersion liquid completely covers the substrate surface SS of the wafer at least in the region under exposure and that the exit-side end area of the projection objective is immersed into the immersion liquid while a finite image-side working distance is set correctly. The entire system is controlled by a central computer COMP.

The projection objective PO includes a plane parallel plate PP arranged at the first pupil surface P1. An exchanging device EX operatively coupled to the central computer COMP is configured to hold at least one correcting element CE having the general shape of the parallel plate PP and having one surface of the plate formed into an predetermined aspheric shape optimized to at least partly compensate for imaging aberration caused by lens heating and other time-dependent effects occuring during operation of the exposure apparatus. The exchanging device EX is configured to replace the plane plate PP by the correcting element CE in response to signals received by the computer COMP indicating that imaging aberrations have increased above a predefined threshold value not acceptable for the desired exposure process. The signals may be provided, for example, by a measuring device (not shown) capable to detect wavefront aberrations in the image surface in measuring intervals between exposure intervals. The signals may also be derived from other indicators responsive to time-dependent effects in the projection objective influencing imaging performance. When the parallel plate PP is replaced by the correcting element CE, the aspheric surface provides a spatial distribution of refractive power of the correcting element such that a substantially field-constant correction of selected imaging aberrations is effected.

The above description of the preferred embodiments has been given by way of example. From the disclosure given, those skilled in the art will not only understand the present invention and its attendant advantages, but will also find apparent various changes and modifications to the structures and methods disclosed. It is sought, therefore, to cover all changes and modifications as fall within the spirit and scope of the invention, as defined by the appended claims, and equivalents thereof.

The contents of all the claims is made part of this description by reference.

**Table 1**

NA = 1.55 ; λ = 193 nm ; image field height y' = 16.75 mm

| SURF | RADIUS | THICKNESS | MATERIAL | INDEX | SEMIDIAM. |
|---|---|---|---|---|---|
| 0 | 0,000000 | 50,912894 | | | 67,0 |
| 1 | 198,187606 | 32,638337 | SILUV | 1,560364 | 99,0 |
| 2 | 2119,275272 | 116,597125 | | | 99,0 |
| 3 | -8102,811429 | 31,017072 | SILUV | 1,560364 | 112,0 |
| 4 | -396,191876 | 1,105494 | | | 112,0 |
| 5 | 375,463491 | 8,372581 1 | SILUV | 1,560364 | 108,0 |
| 6 | 993,877320 | 50,155225 | | | 107,0 |
| 7 | 854,163287 | 27,042126 | SILUV | 1,560364 | 105,0 |
| 8 | -368,005895 | 66,267925 | | | 104,0 |
| 9 | 0,000000 | 10,000000 | SILUV | 1,560364 | 93,0 |
| 10 | 0,000000 | 4,993463 | | | 96,0 |
| 11 | 1116,436603 | 27,386134 | SILUV | 1,560364 | 98,0 |
| 12 | -541,763655 | 1,994818 | | | 99,0 |
| 13 | 172,633907 | 38,342085 | SILUV | 1,560364 | 99,0 |
| 14 | -15316,190761 | 43,567212 | | | 97,0 |
| 15 | -346,530576 | 10,891419 | SILUV | 1,560364 | 86,0 |
| 16 | 976,349017 | 302,319586 | | | 85,0 |
| 17 | -170,111796 | -255,670179 | REFL | | 140,0 |
| 18 | 243,177607 | 295,657906 | REFL | | 164,0 |
| 19 | 167,747071 | 58,929219 | SILUV | 1,560364 | 133,0 |
| 20 | 383,971481 | 63,193374 | | | 128,0 |
| 21 | -9089,180557 | 9,995051 | SILUV | 1,560364 | 104,0 |
| 22 | 98,619971 | 54,505708 | | | 85,0 |
| 23 | 553,085020 | 9,987996 | SILUV | 1,560364 | 86,0 |
| 24 | 210,057052 | 2,551201 | | | 92,0 |
| 25 | 185,744877 | 16,564269 | SILUV | 1,560364 | 94,0 |
| 26 | 412,749772 | 17,158588 | | | 96,0 |
| 27 | 4121,174799 | 10,101794 | SILUV | 1,560364 | 102,0 |
| 28 | -570,087584 | 1,169677 | | | 107,0 |
| 29 | 585,462100 | 34,519719 | SILUV | 1,560364 | 119,0 |
| 30 | -821,316089 | 0,993626 | | | 122,0 |
| 31 | -465,975584 | 56,902690 | SILUV | 1,560364 | 125,0 |
| 32 | -193,846625 | 0,984837 | | | 127,0 |
| 33 | -808,064099 | 8,899146 | SILUV | 1,560364 | 122,0 |
| 34 | -426,087753 | 1,000000 | | | 122,0 |
| 35 | 736,283611 | 16,314030 | SILUV | 1,560364 | 121,0 |
| 36 | -6599,975915 | 1,000000 | | | 120,0 |
| 37 | 284,807984 | 40,403192 | SILUV | 1,560364 | 118,0 |
| 38 | -1493,287438 | 1,000000 | | | 116,0 |
| 39 | 272,285041 | 41,480195 | SILUV | 1,560364 | 109,0 |
| 40 | -524,111405 | 1,000000 | | | 107,0 |
| 41 | 122,996192 | 32,061236 | SILUV | 1,560364 | 84,0 |
| 42 | 503,295522 | 1,000000 | | | 80,0 |
| 43 | 78,729199 | 60,000000 | LUAG | 2,143500 | 60,0 |
| 44 | 0,000000 | 3,100000 | HIINDEX | 1,650000 | 26,0 |
| 45 | 0,000000 | 0,000000 | | | 17,0 |

**Table 1A**

ASPHERIC CONSTANTS

| SRF | 1 | 4 | 6 | 8 | 12 |
|---|---|---|---|---|---|
| K | | 0 | 0 | 0 | 0 |
| C1 | -6,746271 E-08 | -3,249441 E-08 | 4,309998E-08 | 5,394787E-08 | -6,724857E-08 |
| C2 | 4,953953E-12 | -5,246092E-12 | 4,986996E-12 | -9,212775E-13 | -1,529680E-12 |
| C3 | -1,530765E-16 | 6,380381 E-16 | -2,623307E-16 | -2,432025E-17 | 2,729868E-16 |
| C4 | 7,153018E-21 | -2,688261 E-20 | -2,972485E-20 | -1,385827E-21 | -1,253824E-21 |
| C5 | -2,427440E-24 | 6,943058E-25 | 6,952724E-24 | 3,469550E-25 | -2,181156E-24 |
| C6 | 2,905571 E-28 | 6,487343E-30 | -5,603581 E-28 | 3,089271 E-29 | 1,909948E-28 |
| C7 | -1,166968E-32 | -1,040777E-33 | 1,664362E-32 | -1,546007E-33 | -6,063132E-33 |

| SRF | 14 | 15 | 17 | 18 | 20 |
|---|---|---|---|---|---|
| K | 0 | 0 | -2,42854 | -0,30922 | 0 |
| C1 | 1,864311 E-08 | -1,355725E-07 | -5,001843E-08 | -4,371766E-1 0 | -3,814897E-08 |
| C2 | 1,953693E-12 | 3,863311 E-12 | 7,726608E-13 | -1,104472E-15 | 1,772069E-12 |
| C3 | -6,933586E-16 | -9,669369E-17 | -3,001289E-17 | -2,649570E-19 | 1,288942E-17 |
| C4 | 5,925957E-20 | 2,078676E-20 | 9,728990E-22 | 1,520001E-23 | 1,633000E-21 |
| C5 | -3,453503E-24 | -8,290057E-25 | -3,576469E-26 | -8,074095E-28 | -5,303590E-25 |
| C6 | 2,002457E-28 | 7,955027E-29 | 9,063426E-31 | 2,181039E-32 | 3,123028E-29 |
| C7 | -5,954938E-33 | -4,880001 E-33 | -1,147417E-35 | -2,317575E-37 | -6,392938E-34 |

| SRF | 21 | 23 | 25 | 28 | 29 |
|---|---|---|---|---|---|
| K | 0 | 0 | 0 | 0 | 0 |
| C1 | 1,240965E-07 | -1,353374E-07 | 4,315199E-08 | 1,440778E-07 | -7,765642E-09 |
| C2 | 1,205032E-12 | 8,802602E-12 | -1,646147E-11 | 2,217312E-12 | 1,700239E-12 |
| C3 | -5,268525E-16 | -3,389279E-16 | 7,415903E-16 | -7,841003E-16 | -2,681810E-16 |
| C4 | 7,483257E-20 | -3,355305E-19 | 4,862822E-20 | 2,458122E-21 | 5,304205E-20 |
| C5 | -7,371256E-24 | 4,310972E-23 | -1,554751E-23 | -2,765609E-24 | -3,191922E-24 |
| C6 | 4,225469E-28 | -1,804889E-27 | 1,000187E-27 | 5,654608E-28 | 1,974720E-29 |
| C7 | -1,159702E-32 | 3,788539E-32 | -1,485617E-32 | -2,128048E-32 | 1,896629E-33 |

| SRF | 31 | 33 | 36 | 38 | 40 |
|---|---|---|---|---|---|
| K | 0 | 0 | 0 | 0 | 0 |
| C1 | 8,912448E-08 | -2,083154E-08 | 4,547964E-08 | -5,178257E-09 | -1,072677E-08 |
| C2 | -2,995228E-13 | -3,131869E-13 | -7,403140E-13 | 3,439036E-12 | -4,973652E-12 |
| C3 | 2,092613E-18 | -1,005690E-16 | -7,881041 E-17 | -2,016630E-16 | 9,933906E-16 |
| C4 | -1,744814E-20 | 2,990568E-22 | 1,539387E-22 | 1,112083E-20 | -9,153429E-20 |
| C5 | -1,463551 E-26 | -8,678470E-26 | -2,130676E-25 | -6,603379E-25 | 5,669091 E-24 |
| C6 | 9,245638E-29 | 1,818044E-29 | 6,514729E-29 | -1,351722E-29 | -2,120727E-28 |
| C7 | -2,942068E-33 | -1,974631 E-34 | -2,315230E-33 | 1,733417E-33 | 3,406074E-33 |

| SRF | 42 |
|---|---|
| K | 0 |
| C1 | -3,118022E-08 |
| C2 | 2,779796E-11 |
| C3 | -6,844335E-15 |

(continued)

| SRF | 42 |
|---|---|
| C4 | 1,218618E-18 |
| C5 | -1,433904E-22 |
| C6 | 9,934761 E-27 |
| C7 | -2,692466E-31 |

**Table 2**

NA = 1.55 ; λ = 193 nm ; image field height y' = 14.0 mm

| SURF | RADIUS | THICKNESS | MATERIAL | INDEX | SEMIDIAM. |
|---|---|---|---|---|---|
| 0 | 0,000000 | 50,381834 | | | 56,0 |
| 1 | 372,513238 | 18,300842 | SILUV | 1,560364 | 81,0 |
| 2 | 5067,639833 | 49,432483 | | | 82,7 |
| 3 | -619,029461 | 27,291925 | SILUV | 1,560364 | 94,5 |
| 4 | -203,472180 | 81,644819 | | | 96,9 |
| 5 | 159,216324 | 49,469269 | SILUV | 1,560364 | 108,6 |
| 6 | 646,042356 | 2,658393 | | | 105,9 |
| 7 | 373,311655 | 14,240514 | SILUV | 1,560364 | 100,4 |
| 8 | 2996,945142 | 44,519514 | | | 97,8 |
| 9 | 303,826409 | 21,657086 | SILUV | 1,560364 | 75,1 |
| 10 | -522,907787 | 4,999113 | | | 70,8 |
| 11 | 0,000000 | 10,000000 | SILUV | 1,560364 | 66,9 |
| 12 | 0,000000 | 41,698252 | | | 67,7 |
| 13 | -407,238663 | 7,999461 | SILUV | 1,560364 | 71,8 |
| 14 | 1194,691548 | 5,961857 | | | 73,4 |
| 15 | 519,663551 | 14,740678 | SILUV | 1,560364 | 75,6 |
| 16 | -385,881864 | 23,016827 | | | 75,9 |
| 17 | -228,142032 | 10,898995 | SILUV | 1,560364 | 78,0 |
| 18 | -1053,352254 | 316,779679 | | | 79,4 |
| 19 | -196,781652 | -276,780007 | REFL | | 145,6 |
| 20 | 221,223686 | 316,778927 | REFL | | 164,6 |
| 21 | 518,518559 | 13,099104 | SILUV | 1,560364 | 84,0 |
| 22 | 208,136220 | 9,119948 | | | 82,3 |
| 23 | 147,906785 | 9,999267 | SILUV | 1,560364 | 78,7 |
| 24 | 93,759505 | 62,880005 | | | 71,7 |
| 25 | -295,071650 | 9,999510 | SILUV | 1,560364 | 75,8 |
| 26 | 256,866985 | 3,826235 | | | 86,3 |
| 27 | 213,245042 | 22,442850 | SILUV | 1,560364 | 88,8 |
| 28 | -2186,561030 | 10,452392 | | | 91,7 |
| 29 | -573,822698 | 10,066914 | SILUV | 1,560364 | 94,7 |
| 30 | -270,090971 | 1,028563 | | | 99,4 |
| 31 | 13848,630567 | 46,787645 | SILUV | 1,560364 | 116,3 |
| 32 | -302,530442 | 0,998583 | | | 119,1 |
| 33 | -474,369821 | 31,138681 | SILUV | 1,560364 | 120,3 |
| 34 | -226,114816 | 0,998518 | | | 123,5 |
| 35 | -1079,595300 | 29,511982 | SILUV | 1,560364 | 125,2 |
| 36 | -274,044423 | 1,000000 | | | 126,2 |
| 37 | 1117,999360 | 17,931162 | SILUV | 1,560364 | 122,0 |
| 38 | -993,268852 | 1,000000 | | | 120,8 |
| 39 | 193,372627 | 49,752294 | SILUV | 1,560364 | 116,8 |
| 40 | 1733,733122 | 1,000000 | | | 113,9 |

(continued)

NA = 1.55 ; λ = 193 nm ; image field height y' = 14.0 mm

| SURF | RADIUS | THICKNESS | MATERIAL | INDEX | SEMIDIAM. |
|---|---|---|---|---|---|
| 41 | 168,776128 | 38,865464 | SILUV | 1,560364 | 99,7 |
| 42 | -909,735908 | 1,000000 | | | 96,3 |
| 43 | 170,263247 | 18,251593 | SILUV | 1,560364 | 80,1 |
| 44 | 398,774934 | 1,000000 | | | 75,5 |
| 45 | 77,054079 | 60,000000 | LUAG | 2,143500 | 57,9 |
| 46 | 0,000000 | 3,100000 | HIINDEX | 1,650000 | 22,5 |
| 47 | 0,000000 | 0,000000 | | | 14,0 |

**Table 2A**

ASPHERIC CONSTANTS

| SRF | 1 | 6 | 8 | 10 | 14 |
|---|---|---|---|---|---|
| K | 0 | 0 | 0 | 0 | 0 |
| C1 | 3,737991 E-08 | -1,026768E-07 | 1, 1 65968E-07 | 1,279823E-07 | -2,151397E-07 |
| C2 | -5,264950E-12 | 5,435313E-12 | -7,397582E-12 | 1,865957E-12 | -9,539994E-13 |
| C3 | -3,653937E-16 | 5,520081 E-16 | -3,154357E-16 | 4,353292E-16 | 9,326495E-17 |
| C4 | 8,215990E-20 | -9,225755E-20 | 4,278860E-20 | -1,443703E-19 | 3,266233E-19 |
| C5 | -1,114674E-23 | 5,543557E-24 | 9,226768E-25 | 4,146340E-23 | 1,027710E-23 |
| C6 | 1,547307E-27 | -2,088345E-28 | -1,428364E-28 | -5,575053E-27 | -2,554878E-27 |
| C7 | -8,518731 E-32 | 4,227915E-33 | 3,912542E-33 | 2,645864E-31 | -1,160986E-31 |

| SRF | 16 | 17 | 19 | 20 | 22 |
|---|---|---|---|---|---|
| K | 0 | 0 | -2,89900 | -0,23609 | 0 |
| C1 | 1,417088E-07 | 4,320480E-08 | -4,157218E-08 | 3,854062E-10 | -1,791814E-07 |
| C2 | 1,704432E-11 | 1,440124E-11 | 6,838337E-13 | -2,011876E-15 | -2,602253E-11 |
| C3 | 2,942488E-16 | 1,019782E-15 | -2,565891 E-17 | 1,974481 E-19 | 3,240504E-15 |
| C4 | -2,964626E-19 | -7,388937E-20 | 8,022113E-22 | -1,653920E-23 | 3,015849E-19 |
| C5 | 1,242767E-23 | 1,864662E-23 | -2,337687E-26 | 6,063333E-28 | -8,723492E-23 |
| C6 | -4,080381 E-27 | -6,743308E-27 | 4,448681 E-31 | -1,386614E-32 | 7,736771 E-27 |
| C7 | 4,294501 E-31 | 4,577349E-31 | -4,144510E-36 | 1,392276E-37 | -2,831773E-31 |

| SRF | 23 | 25 | 27 | 30 | 31 |
|---|---|---|---|---|---|
| K | 0 | 0 | 0 | 0 | 0 |
| C1 | -1,122902E-07 | -6,053483E-08 | -9,026480E-08 | 1,211676E-07 | 4,255683E-08 |
| C2 | -2,429376E-11 | 1,058340E-12 | 1,625262E-12 | 3,514315E-12 | 4,137763E-12 |
| C3 | 2,478066E-15 | 4,639453E-16 | -4,607351 E-16 | -4,866786E-16 | -4,270122E-16 |
| C4 | 3,588249E-19 | -1,918130E-19 | 5,400682E-20 | -2,143004E-22 | 3,478165E-20 |
| C5 | -5,731528E-23 | 3,878130E-24 | -4,341182E-24 | 9,800131 E-25 | -2,518109E-24 |
| C6 | 4,314967E-27 | 3,294987E-27 | -6,601977E-30 | -1,012966E-28 | 1,039730E-28 |
| C7 | -2,531343E-31 | -3,045182E-31 | 1,052497E-32 | 5,200303E-33 | -1,726149E-33 |

| SRF | 33 | 35 | 38 | 40 | 42 |
|---|---|---|---|---|---|
| K | 0 | 0 | 0 | 0 | 0 |
| C1 | 1,466701 E-08 | -3,937136E-09 | 4,813303E-08 | -7,859477E-09 | 3,044806E-08 |
| C2 | -1,670992E-12 | -1,209357E-13 | -1,154892E-12 | 6,647112E-14 | 4,156658E-12 |

(continued)

| SRF | 33 | 35 | 38 | 40 | 42 |
|---|---|---|---|---|---|
| C3 | 6,764101E-17 | -7,940036E-17 | 8,637107E-18 | -1,925589E-16 | -7,821830E-18 |
| C4 | -4,588193E-21 | 2,678429E-21 | -1,094087E-21 | 4,098044E-21 | -2,142341 E-20 |
| C5 | -1,272961 E-26 | 9,968951 E-26 | 4,531847E-26 | 1,312196E-24 | 1,881903E-24 |
| C6 | -9,235305E-30 | 2,233963E-30 | 6,878312E-30 | -9,899540E-29 | -3,000019E-29 |
| C7 | 6,356566E-34 | -2,743426E-34 | -1,413591 E-34 | 2,336955E-33 | -1,661331 E-33 |

| SRF | 44 |
|---|---|
| K | 0 |
| C1 | 3,881994E-08 |
| C2 | 8,900290E-13 |
| C3 | 3,438552E-17 |
| C4 | 2,422263E-20 |
| C5 | -2,797389E-24 |
| C6 | -8,832538E-28 |
| C7 | 1,766497E-31 |

**Table 3**

NA = 1.36 ; λ = 193 nm ; image field height y' = 15.3 mm

| SURF | RADIUS | THICKNESS | MATERIAL | INDEX | SEMIDIAM. |
|---|---|---|---|---|---|
| 0 | 0,000000 | 35,011188 | | | 61,0 |
| 1 | 382,185274 | 19,022510 | SILUV | 1,560491 | 76,3 |
| 2 | 3355,596936 | 28,816162 | | | 78,2 |
| 3 | 477,218860 | 22,631304 | SILUV | 1,560491 | 88,5 |
| 4 | -922,196146 | 38,663099 | | | 89,6 |
| 5 | -1118,102672 | 50,000005 | SILUV | 1,560491 | 94,1 |
| 6 | -166,502079 | 68,193522 | | | 96,5 |
| 7 | -129,699842 | 10,289512 | SILUV | 1,560491 | 77,3 |
| 8 | -568,486045 | 1,404508 | | | 81,1 |
| 9 | 360,871595 | 36,412765 | SILUV | 1,560491 | 83,7 |
| 10 | -221,344939 | 41,316186 | | | 84,0 |
| 11 | 0,000000 | 10,000000 | SILUV | 1,560491 | 72,7 |
| 12 | 0,000000 | 4,999963 | | | 74,5 |
| 13 | 558,300871 | 22,827559 | SILUV | 1,560491 | 78,0 |
| 14 | -433,013634 | 62,173564 | | | 79,5 |
| 15 | 441,363089 | 31,099429 | SILUV | 1,560491 | 89,5 |
| 16 | -341,473462 | 1,170281 | | | 89,5 |
| 17 | 1222,280168 | 28,519264 | SILUV | 1,560491 | 87,1 |
| 18 | -247,039506 | 8,650761 | | | 85,9 |
| 19 | -185,932756 | 10,099134 | SILUV | 1,560491 | 84,0 |
| 20 | 182,286218 | 55,304594 | | | 81,0 |
| 21 | -119,613521 | 10,814913 | SILUV | 1,560491 | 81,8 |
| 22 | 4853,350949 | 2,068171 | | | 100,7 |
| 23 | 496,760047 | 50,132029 | SILUV | 1,560491 | 111,1 |
| 24 | -245,672304 | 88,351331 | | | 114,4 |
| 25 | 444,836588 | 64,064520 | SILUV | 1,560491 | 145,2 |
| 26 | -295,503989 | 76,306203 | | | 145,2 |
| 27 | 0,000000 | -314,280203 | REFL | | 132,8 |
| 28 | -247,137511 | -77,271453 | SILUV | 1,560491 | 160,0 |
| 29 | 810,350730 | -208,473351 | | | 158,0 |
| 30 | 294,775031 | -12,500000 | SILUV | 1,560491 | 88,1 |

(continued)

NA = 1.36 ; λ = 193 nm ; image field height y' = 15.3 mm

| SURF | RADIUS | THICKNESS | MATERIAL | INDEX | SEMIDIAM. |
|---|---|---|---|---|---|
| 31 | -286,941223 | -102,432781 | | | 84,7 |
| 32 | 180,414660 | -12,500000 | SILUV | 1,560491 | 87,2 |
| 33 | 10035,763024 | -26,892770 | | | 94,5 |
| 34 | 194,482349 | 26,892770 | REFL | | 96,0 |
| 35 | 10035,763024 | 12,500000 | SILUV | 1,560491 | 94,5 |
| 36 | 180,414660 | 102,432781 | | | 87,2 |
| 37 | -286,941223 | 12,500000 | SILUV | 1,560491 | 84,7 |
| 38 | 294,775031 | 208,473351 | | | 88,1 |
| 39 | 810,350730 | 77,271453 | SILUV | 1,560491 | 158,0 |
| 40 | -247,137511 | 314,280047 | | | 160,0 |
| 41 | 0,000000 | -78,000672 | REFL | | 133,2 |
| 42 | -339,895111 | -48,598415 | SILUV | 1,560491 | 146,4 |
| 43 | 1373,456750 | -0,999276 | | | 145,7 |
| 44 | -504,213001 | -36,238195 | SILUV | 1,560491 | 142,0 |
| 45 | 5356,202306 | -0,999341 | | | 139,7 |
| 46 | -140,155457 | -64,600486 | SILUV | 1,560491 | 114,8 |
| 47 | -334,057880 | -20,315663 | | | 100,9 |
| 48 | 6443,720921 | -9,999173 | SILUV | 1,560491 | 96,9 |
| 49 | -92,325569 | -33,314435 | | | 73,6 |
| 50 | -368,587379 | -9,998836 | SILUV | 1,560491 | 73,0 |
| 51 | -149,804097 | -48,568442 | | | 69,7 |
| 52 | 102,768893 | -9,999251 | SILUV | 1,560491 | 69,8 |
| 53 | -268,102298 | -17,334160 | | | 86,4 |
| 54 | -894,642180 | -45,003218 | SILUV | 1,560491 | 91,1 |
| 55 | 341,239295 | -3,399868 | | | 107,0 |
| 56 | 555,007734 | -98,611795 | SILUV | 1,560491 | 110,1 |
| 57 | 161,562349 | -0,999537 | | | 135,5 |
| 58 | 1424,973978 | -41,439862 | SILUV | 1,560491 | 148,9 |
| 59 | 240,839763 | -0,999688 | | | 152,2 |
| 60 | -861,203459 | -50,810112 | SILUV | 1,560491 | 158,2 |
| 61 | 771,781511 | -33,917678 | | | 160,0 |
| 62 | -546,418872 | -47,441425 | SILUV | 1,560491 | 160,0 |
| 63 | 1544,671665 | 18,607639 | | | 159,4 |
| 64 | 0,000000 | -19,607228 | | | 160,7 |
| 65 | -280,711459 | -56,538959 | SILUV | 1,560491 | 148,9 |
| 66 | -2833,791703 | -0,998656 | | | 145,5 |
| 67 | -151,439302 | -51,205187 | SILUV | 1,560491 | 109,5 |
| 68 | -2634,011137 | -1,000000 | | | 101,4 |
| 69 | -60,618256 | -52,074212 | SILUV | 1,560491 | 54,6 |
| 70 | 0,000000 | -3,000000 | H2OV193 | 1,436823 | 23,6 |
| 71 | 0,000000 | 0,000000 | | | 15,3 |

**Table 3A**

ASPHERIC CONSTANTS

| SRF | 2 | 8 | 23 | 26 | 29 |
|---|---|---|---|---|---|
| K | 0 | 0 | 0 | 0 | 0 |
| C1 | 1,347468E-08 | 6,034781 E-08 | -1,016331 E-08 | 1,654839E-08 | -1,366914E-08 |
| C2 | 2,207912E-12 | 1,030721E-12 | 9,975098E-13 | 1,248738E-13 | 1,191027E-13 |

(continued)

ASPHERIC CONSTANTS

| SRF | 2 | 8 | 23 | 26 | 29 |
|-----|---|---|----|----|----|
| C3 | 9,965819E-17 | 4,363266E-16 | -6,682385E-17 | -2,875416E-19 | -1,501877E-18 |
| C4 | 3,306256E-20 | -1,299667E-19 | 2,186818E-21 | -1,140427E-23 | 3,212707E-23 |
| C5 | -6,720858E-24 | 1,514107E-23 | -2,369614E-26 | -9,698834E-29 | -7,689882E-28 |
| C6 | 5,149578E-28 | -7,081928E-28 | -3,385824E-31 | 7,791686E-33 | 9,534303E-33 |

| SRF | 33 | 35 | 39 | 43 | 44 |
|-----|----|----|----|----|----|
| K | 0 | 0 | 0 | 0 | 0 |
| C1 | 3,177312E-08 | 3,177312E-08 | -1,366914E-08 | -2,403138E-09 | -4,337241 E-09 |
| C2 | -1,077719E-12 | -1,077719E-12 | 1,191027E-13 | -9,726816E-14 | -1,770230E-13 |
| C3 | 5,276309E-17 | 5,276309E-17 | -1,501877E-18 | -3,883610E-18 | -6,575209E-18 |
| C4 | -2,529805E-21 | -2,529805E-21 | 3,212707E-23 | 1,766230E-22 | 7,684192E-23 |
| C5 | 1,307247E-25 | 1,307247E-25 | -7,689882E-28 | -3,969746E-27 | -8,791789E-28 |
| C6 | -7,341513E-30 | -7,341513E-30 | 9,534303E-33 | 6,671253E-32 | 6,418850E-32 |

| SRF | 54 | 56 | 58 | 60 | 63 |
|-----|----|----|----|----|----|
| K | 0 | 0 | 0 | 0 | 0 |
| C1 | 3,845765E-08 | 5,917411 E-08 | 3,947900E-08 | -1,247993E-10 | 1,795292E-08 |
| C2 | 3,149540E-12 | -1,711396E-12 | -1,804073E-13 | -1,251219E-13 | -1,289060E-12 |
| C3 | -1,246913E-16 | -3,877057E-17 | -3,154989E-17 | 2,971143E-17 | 5,175936E-17 |
| C4 | 6,730427E-21 | -6,143291 E-22 | 2,071680E-21 | -8,028081 E-22 | -1,070499E-21 |
| C5 | -1,009901 E-24 | 5,363788E-25 | -8,838538E-26 | 2,050122E-26 | 1,388166E-26 |
| C6 | -3,983455E-29 | -2,016608E-29 | 1,721616E-30 | -3,004535E-31 | -1,098382E-31 |

| SRF | 66 | 68 |
|-----|----|----|
| K | 0 | 0 |
| C1 | 2,376124E-08 | -2,061112E-08 |
| C2 | -4,937362E-13 | -2,944479E-12 |
| C3 | 2,984424E-17 | 2,901078E-16 |
| C4 | -1,965712E-21 | -2,145724E-20 |
| C5 | 5,583512E-26 | 1,078059E-24 |
| C6 | -5,689719E-31 | -3,014279E-29 |

**Claims**

1. A projection objective comprising:

    a plurality of optical elements arranged to image an object field arranged in an object surface onto an image field arranged in an image surface of the projection objective without pupil obscuration, the optical elements forming:

       a first, refractive objective part generating a first intermediate image from radiation coming from the object surface and including a first pupil surface;
       an imaging subsystem immediately following the first objective part configured to image the first intermediate image onto the image surface;

    wherein optical elements arranged between the object surface and the first pupil surface form a Fourier lens group configured to produce a chief ray angle $CRA_{P1}<25°$ at the first pupil surface.

2. The projection objective according to claim 1, wherein the chief ray angle $CRA_{P1}$ is less than 22° at the first pupil surface.

3. The projection objective according to claim 1 or 2, wherein the Fourier lens group has a focal length $f_{FLG}$, the projection objective has a distance L between the object surface and the image surface, and the condition:

$$| \, f_{FLG}/L \, | > 0.08 \text{ holds.}$$

4. The projection objective according to any one of the preceding claims, wherein a pupil space is defined around the first pupil surface in a region where a marginal ray height MRH is substantially greater than the chief ray height CRH such that the condition $|RHR| < 0.4$ is fulfilled for a ray height ratio RHR = CRH/MRH, and wherein an axial extension of the pupil space is at least 10 mm.

5. The projection objective according to any one of the preceding claims, wherein a pupil space is defined around the first pupil surface in a region where a marginal ray height MRH is substantially greater than the chief ray height CRH such that the condition $|RHR| < 0.4$ is fulfilled for a ray height ratio RHR = CRH/MRH, and wherein the pupil space includes at least one axial position where a free space defined between mutually facing optical surfaces of optical elements upstream and downstream of the axial position is at least 10mm, where the free space is defined as an axial distance between reference planes orthogonal to the optical axis and touching the optical surfaces upstream and downstream of the axial position, wherein preferably the free space measures at least 40 mm and/or wherein the free space includes the position of the pupil surface and/or wherein at least one lens is positioned between the pupil surface and the free space.

6. The projection objective according to any one of the preceding claims, wherein a radiation beam between the object surface and the image surface at a given numerical aperture NA defines a first optical free diameter $D_1$ in the first pupil surface and a third optical free diameter $D_3$ in the third pupil surface, wherein a diameter ratio $D_1/D_3$ fulfills the condition: $1/A < D_1/D_3 < A$, where A = 2.

7. The projection objective according to any one of the preceding claims, wherein NA > 0.80.

8. The projection objective according to any one of the preceding claims, wherein a size of the first pupil obeys the condition: $| \, MRH_{P1}/k_{CR} \, | > 160$, where $MRH_{P1}$ is a marginal ray height at a first pupil surface and $k_{CR}$ is a direction cosine of the chief ray of an outermost field point.

9. The projection objective according to any one of the preceding claims, wherein the projection objective comprises at least one correcting element configured to be inserted into or inserted in a pupil space at or optically close to the first pupil surface, the projection objective preferably further comprising an exchanging device operatively coupled to the at least one correcting element configured to optionally insert the correcting element into the beam path or remove the correcting element out of the beam path at the first pupil surface.

10. The projection objective according to claim 9, wherein the projection objective comprises a first correcting element and at least one second correcting element, both configured to be inserted into the pupil space or inserted in the pupil space at the first pupil surface.

11. The projection objective according to claim 9 or 10, wherein at least one correcting element is selected from the group consisting of:

    a) a transparent polarization element influencing the polarization state of radiation transiting the polarization element;
    b) a refractive correcting element;
    c) an aspherical refractive optical element having a predefined spatial distribution of refractive power, wherein preferably the aspherical refractive optical element has an aspherical surface having a deformation (deviation from a best fitting spherical or planar surface) of at least one of less than 500 nm and less than 5$\lambda$, where $\lambda$ is the operating wavelength of the projection objective;
    d) a plane parallel plate inserted or insertable orthogonal to the optical axis, where at least one surface of the plate is shaped as an aspheric surface to obtain a desired spatial distribution of refractive power substantially deviating from a spatial distribution of refractive power of a spherical or planar surface;
    e) an active correcting element having a variable structure configured to be varied to obtain a variable optical correction effect;

f) a transmission filter element having a transmission locally varying across a utilized diameter of the filter element.

12. The projection objective according to any one of the preceding claims, wherein an aperture stop is positioned at the first pupil surface, wherein preferably the aperture stop is a variable aperture stop allowing to adjust the size of the free diameter of the aperture at the first pupil surface.

13. The projection objective according to any one of the preceding claims, wherein the projection objective is a catadioptric projection objective including at least one curved mirror, wherein preferably the plurality of optical elements are arranged to image an off-axis object field onto an off-axis image field.

14. The projection objective according to any one of the preceding claims, wherein the projection objective is a catadioptric projection objective and wherein the imaging subsystem immediately following the first objective part configured to image the first intermediate image onto the image surface comprises:

a second objective part including at least one concave mirror imaging the first intermediate image into a second intermediate image and
including a second pupil surface optically conjugated to the first pupil surface; and
a third, refractive objective part imaging the second intermediate image onto the image surface and including a third pupil surface optically conjugated to the first and second pupil surface,

wherein preferably the catadioptric projection objective is designed as an in-line-system having one straight optical axis common to all optical elements of the projection objective and/or
the second objective part has a mirror group having an object-side mirror group entry for receiving radiation coming from the object surface and an image-side mirror group exit for exiting radiation emerging from the mirror group exit towards the image surface, where the mirror group includes an even number of concave mirrors and/or wherein the second objective part has exactly two concave mirrors, wherein preferably all concave mirrors of the mirror group are optically remote from a pupil surface.

15. The projection objective according to claim 13, wherein the second objective part comprises exactly one concave mirror, and wherein the projection objective has a first folding mirror and a second folding mirror, wherein preferably the first folding mirror is arranged to deflect radiation coming from the object surface in the direction of the concave mirror, and a second folding mirror is arranged to deflect radiation coming from the concave mirror in the direction of the image surface or wherein the first folding mirror and a second folding mirror are arranged downstream of the concave mirror such that the image surface is oriented parallel to the object surface.

16. A method of fabricating semiconductor devices and other types of microdevices utilizing a projection objective, the method comprising:

placing a mask providing a prescribed pattern in the object surface of the projection objective;
illuminating the mask with ultraviolet radiation having a prescribed wavelength;
projecting an image of the pattern onto the photosensitive substrate with a projection objective according to any one of the preceding claims 1 to 15; and
adjusting the imaging characteristics of the projection objective by inserting at least one correcting element into a pupil space or removing a correcting element from the pupil space at the first pupil surface.

17. The method according to claim 16, wherein the adjusting step is performed at the location of use of the projection objective, wherein preferably the adjusting step is performed during at least one of an exchange of substrates and an exchange between different masks and a change between different illumination settings.

18. The method according to claim 16 or 17, wherein he step of adjusting the imaging characteristics of the projection objective is performed by inserting at least two correcting element into a pupil space or removing one or more of at least two correcting elements from the pupil space at the first pupil surface.

19. The method according to claim 16, 17 or 18, wherein imaging aberrations or properties influencing imaging aberrations associated with time-dependent variations of optical properties of the projection system are detected by a detector generating sensing signals indicative of that time-dependent changes, and at least one correcting element is introduced into a pupil space or removed from the pupil space to compensate at least partly the time-dependent changes.

20. A method of fabricating semiconductor devices and other types of microdevices comprising:

    placing a mask providing a prescribed pattern in the object surface of the projection objective;
    illuminating the mask with ultraviolet radiation having a prescribed wavelength;
    projecting an image of the pattern onto the photosensitive substrate utilizing a projection objective comprising a plurality of optical elements arranged to image an object field arranged in an object surface onto an image field arranged in an image surface of the projection objective, the optical elements forming:

    a first, refractive objective part generating a first intermediate image from radiation coming from the object surface and including a first pupil surface; and
    an imaging subsystem immediately following the first objective part configured to image the first intermediate image onto the image surface; and
    adjusting the imaging characteristics of the projection objective by inserting at least one correcting element into a pupil space or removing a correcting element from the pupil space at the first pupil surface.

21. The method according to claim 20, wherein the adjusting step is performed at the location of use of the projection objective, wherein preferably the adjusting step is performed during at least one of an exchange of substrates and an exchange between different masks and a change between different illumination settings.

22. The method according to claim 20 or 21, wherein the step of adjusting the imaging characteristics of the projection objective is performed by inserting at least two correcting element into a pupil space or removing one or more of at least two correcting elements from the pupil space at the first pupil surface.

23. The method according to claim 20, 21 or 22, wherein imaging aberrations or properties influencing imaging aberrations associated with time-dependent variations of optical properties of the projection system are detected by a detector generating sensing signals indicative of that time-dependent changes, and at least one correcting element is introduced into a pupil space or removed from the pupil space to compensate at least partly the time-dependent changes.

24. The method according to any one of claims 20 to 23, wherein the pupil space is defined around the first pupil surface in a region where a marginal ray height MRH is substantially greater than the chief ray height CRH such that the condition |RHR| < 0.4 is fulfilled for a ray height ratio RHR = CRH/MRH, and wherein an axial extension of the pupil space is at least 10 mm.

25. A projection exposure apparatus comprising:

    a light source generating primary radiation;
    an illumination system forming the primary radiation to generate illumination radiation incident on a mask bearing a pattern; and
    a projection objective projecting an image of the pattern onto a radiation-sensitive substrate,

    wherein the projection objective is configured according to any one of claims 1 to 15.

26. The projection exposure apparatus according to claim 25, further comprising:

    an exchanging device configured to insert at least one correcting element into a pupil space or removing at least one correcting element from a pupil space at the first pupil surface, wherein preferably the exchanging device is configured to insert at least two correcting elements into the pupil space or removing one or more of at least two correcting elements from the pupil space at the first pupil surface.

27. The method according to claim 25 or 26, wherein the pupil space is defined around the first pupil surface in a region where a marginal ray height MRH is substantially greater than the chief ray height CRH such that the condition |RHR| < 0.4 is fulfilled for a ray height ratio RHR = CRH/MRH, and wherein an axial extension of the pupil space is at least 10 mm.

28. A projection objective comprising:

    a plurality of optical elements arranged to image an object field arranged in an object surface onto an image

23

field arranged in an image surface of the projection objective, the optical elements forming:

a first, refractive objective part generating a first intermediate image from radiation coming from the object surface and including a first pupil surface; and

an imaging subsystem immediately following the first objective part configured to image the first intermediate image onto the image surface;

wherein a size of a first pupil at the first pupil surface obeys the condition: $| MRH_{P1}/k_{CR} |> 70$, where $MRH_{P1}$ is a marginal ray height at the first pupil surface and $k_{CR}$ is a direction cosine of the chief ray of an outermost field point.

29. The projection objective according to claim 28, wherein the imaging subsystem includes at least two cascaded imaging objective parts, such that the projection objective includes two or more real intermediate images.

30. The projection objective according to claim 28 or 29, wherein a pupil space is defined around the first pupil surface in a region where a marginal ray height MRH is substantially greater than the chief ray height CRH such that the condition $|RHR|< 0.4$ is fulfilled for a ray height ratio RHR = CRH/MRH, and wherein the pupil space includes at least one axial position where a free space defined between mutually facing optical surfaces of optical elements upstream and downstream of the axial position is at least 10mm, where the free space is defined as an axial distance between reference planes orthogonal to the optical axis and touching the optical surfaces upstream and downstream of the axial position.

31. The projection objective according to any one of claims 28 to 30, wherein NA > 0.80.

32. A projection exposure apparatus comprising:

a light source generating primary radiation;

an illumination system forming the primary radiation to generate illumination radiation incident on a mask bearing a pattern; and

a projection objective projecting an image of the pattern onto a radiation-sensitive substrate, the projection objective comprising a plurality of optical elements arranged to image an object field arranged in an object surface onto an image field arranged in an image surface of the projection objective, the optical elements forming:

a first, refractive objective part generating a first intermediate image from radiation coming from the object surface and including a first pupil surface; and

an imaging subsystem immediately following the first objective part configured to image the first intermediate image onto the image surface;

an exchanging device configured to insert at least one correcting element into a pupil space or removing a correcting element from a pupil space at the first pupil surface.

33. The projection exposure apparatus according to claim 32, wherein the exchanging device is configured to insert at least two correcting elements into the pupil space or removing one or more of at least two correcting elements from the pupil space at the first pupil surface.

*Fig. 1*

Fig. 1A

EP 1 927 891 A1

_Fig. 2_

Fig. 3

Fig. 4

**European Patent Office**

**EUROPEAN SEARCH REPORT**

Application Number

EP 06 02 4790

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/036832 A1 (SCHULTZ JORG [DE] ET AL SCHULTZ JOERG [DE] ET AL) 28 March 2002 (2002-03-28) * paragraphs [0049], [0084], [0085]; figure 9 * | 1,2,4,5, 8,25,27, 28,30 | INV. G03F7/20 G02B17/08 |
| X | WO 2006/005547 A (ZEISS CARL SMT AG [DE]; SHAFER DAVID [US]; ULRICH WILHELM [DE]; DODOC) 19 January 2006 (2006-01-19) * pages 29-32; figure 16 * | 1,7, 12-14, 28,29 | |
| X | WO 2005/069055 A (ZEISS CARL SMT AG [DE]; SHAFER DAVID [US]; ULRICH WILHELM [DE]; DODOC) 28 July 2005 (2005-07-28) * pages 38-40; figures 10,11 * | 1,13, 16-19 | |
| X | * page 59; figure 30 * | 32 | |
| D,X | WO 2005/111689 A (ZEISS CARL SMT AG [DE]; DODOC AURELIAN [DE]; ULRICH WILHELM [DE]; EPPL) 24 November 2005 (2005-11-24) * pages 37-39; figure 12 * | 1,13,15 | |
| X | US 2005/002111 A1 (GRUNER TORALF [DE] ET AL) 6 January 2005 (2005-01-06) | 20,21,32 | TECHNICAL FIELDS SEARCHED (IPC) G03F G02B |
| Y | * paragraph [0055]; claim 80; figure 1 * | 23 | |
| Y | US 2006/077371 A1 (WEGMANN ULRICH [DE] ET AL) 13 April 2006 (2006-04-13) * paragraphs [0006], [0007] * | 23 | |

The present search report has been drawn up for all claims

| Place of search | Date of completion of the search | Examiner |
|---|---|---|
| Munich | 4 October 2007 | Eisner, Klaus |

EPO FORM 1503 03.82 (P04C01)

## ANNEX TO THE EUROPEAN SEARCH REPORT
## ON EUROPEAN PATENT APPLICATION NO.

EP 06 02 4790

This annex lists the patent family members relating to the patent documents cited in the above-mentioned European search report.
The members are as contained in the European Patent Office EDP file on
The European Patent Office is in no way liable for these particulars which are merely given for the purpose of information.

04-10-2007

| Patent document cited in search report | | Publication date | Patent family member(s) | | Publication date |
|---|---|---|---|---|---|
| US 2002036832 | A1 | 28-03-2002 | NONE | | |
| WO 2006005547 | A | 19-01-2006 | EP | 1771771 A1 | 11-04-2007 |
| WO 2005069055 | A | 28-07-2005 | EP | 1709472 A2 | 11-10-2006 |
| | | | JP | 2007518125 T | 05-07-2007 |
| | | | KR | 20060129379 A | 15-12-2006 |
| WO 2005111689 | A | 24-11-2005 | CN | 1985206 A | 20-06-2007 |
| | | | EP | 1751601 A2 | 14-02-2007 |
| US 2005002111 | A1 | 06-01-2005 | NONE | | |
| US 2006077371 | A1 | 13-04-2006 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060056064 A1
- US 6660608 B1
- US 200302344912 A1
- US 20040233405 A1
- WO 2005111689 A2
- WO 2005040890 A2
- US 20050185269 A1
- US 20050190435 A1
- US 6504597 B2
- US 5805273 A
- US 6104472 A
- US 20050190435 A